(19) Europäisches Patentamt European Patent Office Office européen des brevets

(11) **EP 2 100 987 B1**

(12) **EUROPEAN PATENT SPECIFICATION**

(45) Date of publication and mention
of the grant of the patent:
**28.01.2015 Bulletin 2015/05**

(51) Int Cl.:
***C23C 28/00*** (2006.01)    ***B32B 15/08*** (2006.01)
***C25D 5/10*** (2006.01)    ***C25D 7/06*** (2006.01)
***H05K 1/09*** (2006.01)

(21) Application number: **07830832.7**

(22) Date of filing: **30.10.2007**

(86) International application number:
**PCT/JP2007/071098**

(87) International publication number:
**WO 2008/053878 (08.05.2008 Gazette 2008/19)**

(54) **SURFACE TREATED COPPER FOIL, SURFACE TREATED COPPER FOIL WITH VERY THIN PRIMER RESIN LAYER, METHOD FOR MANUFACTURING THE SURFACE TREATED COPPER FOIL, AND METHOD FOR MANUFACTURING THE SURFACE TREATED COPPER FOIL WITH VERY THIN PRIMER RESIN LAYER**

OBERFLÄCHENBEHANDELTE KUPFERFOLIE, OBERFLÄCHENBEHANDELTE KUPFERFOLIE MIT SEHR DÜNNER PRIMERHARZSCHICHT, VERFAHREN ZUR HERSTELLUNG DER OBERFLÄCHENBEHANDELTEN KUPFERFOLIE UND VERFAHREN ZUR HERSTELLUNG DER OBERFLÄCHENBEHANDELTEN KUPFERFOLIE MIT SEHR DÜNNER PRIMERHARZSCHICHT

FEUILLE DE CUIVRE TRAITÉE EN SURFACE, FEUILLE DE CUIVRE TRAITÉE EN SURFACE AVEC UNE COUCHE TRÈS MINCE DE RÉSINE DE PRIMAIRE, PROCÉDÉ DE FABRICATION DE LA FEUILLE DE CUIVRE TRAITÉE EN SURFACE ET PROCÉDÉ DE FABRICATION DE LA FEUILLE DE CUIVRE TRAITÉE EN SURFACE PA

(84) Designated Contracting States:
**AT BE BG CH CY CZ DE DK EE ES FI FR GB GR HU IE IS IT LI LT LU LV MC MT NL PL PT RO SE SI SK TR**

(30) Priority: **31.10.2006 JP 2006295614**

(43) Date of publication of application:
**16.09.2009 Bulletin 2009/38**

(73) Proprietor: **Mitsui Mining & Smelting Co., Ltd Tokyo 141-8584 (JP)**

(72) Inventors:
• **MATSUNAGA, Tetsuhiro**
  **Ageo-shi**
  **Saitama 362-0021 (JP)**
• **MATSUSHIMA, Toshifumi**
  **Ageo-shi**
  **Saitama 362-0021 (JP)**
• **SATO, Tetsuro**
  **Ageo-shi**
  **Saitama 362-0021 (JP)**

(74) Representative: **Bohmann, Armin K.**
**Bohmann**
**Anwaltssozietät**
**Nymphenburger Straße 1**
**80335 München (DE)**

(56) References cited:
**EP-A1- 0 637 902      EP-A2- 0 431 501**
**EP-A2- 1 006 763      JP-A- 01 109 796**
**JP-A- 2004 047 681      JP-A- 2005 053 218**
**JP-A- 2006 052 441      US-B1- 6 248 401**

## Description

Technical Field

The present invention relates to a chromium-free surface-treated copper foil, a surface-treated copper foil with a very thin primer resin layer, a method for manufacturing the surface-treated copper foil, and a method for manufacturing the surface-treated copper foil with a very thin primer resin layer. Especially, the present invention provides a surface-treated copper foil having an excellent performance as a copper foil for a printed wiring board, even chromium is not included as the element of a surface treatment for rust-proofing and the like.

Background Art

A chromium component has been broadly used as an element for a rust-proofing and/or a surface-improving in a copper foil for a printed wiring board through chromium plating or chromate treatment. Especially, a chromate treatment is popularly used for commercially-available copper foils. When the chromium component is present as a chromium compound, the oxidation valence is either three or six. Hexavalent chromium is most toxic on living creatures, and hexavalent chromium compounds also have a much higher mobility in the soil.

Accordingly, under the EU (European Union) ELV directives, a proposal was adopted to prohibit the use of materials which have an environmental burden, such as lead, hexavalent chromium, mercury, and cadmium, in new automobiles registered in the EU market after July 1, 2003. Further, in the electrical and electronic industries, final agreement has been reached on the EU WEEE (Waste Electrical and Electronic Equipment) directive and the RoHS (Restriction on Hazardous Substances) directive, so that the use of six substances, including hexavalent chromium ($Cr^{6+}$), as specified hazardous substances used in waste electrical and electronic devices are restricted due to the fact that there is still an environmental risk even if collected separately. Printed wiring boards are also included to these restrictions.

On the other hand, the transportation of harmful waste substances across boarders has started globally from the 1970s. In the 1980s, problems such as the occurrence of environmental pollution due to the dumping of harmful waste substances in developing countries transported from developed countries have come out. As a result, the Basel Convention on the Control of Transboundary Movements of Hazardous Wastes and their Disposal which prescribed an international framework and procedures etc. concerning regulation of the transportation of certain waste substances across boarders is created. The treaty also came into force in Japan in 1993.

Further, because of the recent increase of critical mind on environmental problems, even when trivalent chromium is used, it may be converted into hexavalent chromium by wrong waste treatment and/or it may be determined as being hexavalent chromium by wrong analysis method. Considering such matters, investigations have been made to utilize the copper foil for a printed wiring board in which the component chromium itself is not used.

Patent Document 1 discloses a metal foil having an adhesion promotion layer on at least one surface, **characterized in that** the adhesion promotion layer includes at least one silane coupling agent, and chromium is not included. The concept disclosed is a copper foil without chromium, and is **characterized in that** a base surface of the metal foil under the adhesion promotion layer is not roughened, or the base surface is free from a zinc layer or chromium layer. Further, the document discloses a metal foil comprising a metal layer provided between the surface of the metal foil and the adhesion promotion layer and the metal constituting the metal layer is selected from among the group consisting of indium, tin, nickel, cobalt, brass, bronze, and a mixture of two or more of these metals. In addition, a metal foil comprising a metal layer provided between the surface of the metal foil and the adhesion promotion layer and the metal constituting the metal layer is selected from among the group consisting of tin, a chromium-zinc mixture, nickel, molybdenum, aluminum, and a mixture of two or more of these metals is also disclosed.

Next, Patent Document 2 directing to provide an electro-deposited copper foil for a printed wiring board which does not contain harmful chromium and is very environmentally-friendly, discloses a copper foil for a printed wiring board **characterized in that** a metal layer or alloy layer composed of one or more metals selected from nickel, molybdenum, cobalt, and zinc is formed on the copper foil, a coupling agent layer is formed on the metal layer or alloy layer, and an adhesion-promoting layer containing a linear polymer is formed on the coupling agent layer.

[Patent Document 1] Japanese Patent Laid-Open No. 7-170064
[Patent Document 2] Japanese Patent Laid-Open No. 2004-47681

Disclosure of the Invention

Problems to be Solved by the Invention

However, the invention disclosed in Patent Document 1 is not practical as can be realized from the investigation of the disclosures. And unfortunately, except for the contents described in the Examples, the disclosed contents may be considered to be impossible to perform. Further, although Patent Document 1 has an object to provide a chromium-free copper foil, a combination of zinc and chromium employed as a stabilizing agent layer can be found in the descriptions in the Examples of Patent Document 1. Therefore, Patent Document 1 does not provide a complete chromium-free copper foil.

Further, according to the disclosure in Patent Document 2, the properties of a copper clad laminate obtained by using the copper foil for a printed wiring board and a FR-5 grade prepreg (GEA-679N) are shown in a table. In the table, the peel strength as-received and the peel loss after immersing in a hydrochloric acid are listed. However, widths of the circuit used to obtain these values are not disclosed. Accordingly, the inventors of the present invention prepared the copper foil for a printed wiring board disclosed in Patent Document 2 and examined. Using a FR-4 grade prepreg, which is the most widely-used for printed wiring board production, the peel strength in a fine circuit of which width of 1 mm or less was measured. Then, it was confirmed that both the peel loss after immersing in a hydrochloric acid and the peel loss after boiling are quite big. It means that the copper foil disclosed in Patent Document 2 is not suitable for formation of a fine pitch circuit.

As is clear in the descriptions above, metal components other than copper provided on the surface of the copper foil are required to assure long-term shelf life of a copper foil for circuit board applications by assuring in terms of peel strength, peel loss after boiling, peel loss after immersing in a hydrochloric acid and the like. Such a layer is generally called a rust-proofing treatment layer. However, depending on the kind of the rust-proofing treatment layer, the difference in the adhesion properties with the substrate resins remarkably affects on the peel strength, the chemical resistance against to the peel loss, the moisture absorption resistance against to the peel loss, the solder blister and the like of the circuit after manufacturing of the printed wiring board.

Therefore, a surface-treated copper foil which does not include chromium in the rust-proofing treatment layer of an electro-deposited copper foil and satisfies the basic requirements on peel strength, the chemical resistance against to the peel loss, the moisture absorption resistance against to the peel loss, the solder blister and the like in the circuit in processing of the printed wiring board has been required.

Means to Solve the Problems

Accordingly, the present inventors thought out means to satisfy the basic characteristics required for a copper foil for a printed wiring board without a chromium-containing rust-proofing treatment layer such as a chromate treatment, by applying a tin layer as a rust-proofing treatment layer on a surface of an electro-deposited copper foil positively to obtain good adhesion properties with a substrate resin.

Surface-treated Copper Foil According to the Present Invention: A chromium-free surface-treated copper foil according to the present invention as defined in the claims comprises a rust-proofing treatment layer and a silane coupling agent layer on a bonding surface of an electro-deposited copper foil to an insulating resin substrate, **characterized in that** the rust-proofing treatment layer is formed by stacking a nickel alloy layer having a thickness by weight of 5 mg/m$^2$ to 50 mg/m$^2$ and a tin layer having a thickness by weight of 5 mg/m$^2$ to 40 mg/m$^2$ in this order on the copper foil, and the silane coupling agent layer is provided on a surface of the rust-proofing treatment layer, wherein the nickel alloy layer is composed of at least one selected from nickel-molybdenum, nickel-zinc, and nickel-molybdenum-cobalt, wherein the rust-proofing treatment layer has a total thickness by weight of a nickel alloy and tin of 10 mg/m$^2$ to 70 mg/m$^2$, and wherein the rust-proofing treatment layer has a ratio [nickel amount in the nickel alloy]/[tin amount] of 0.25 to 10.

Further, the surface-treated copper foil according to the present invention is preferable to be subjected a roughening treatment to the bonding surface of the electro-deposited copper foil, to obtain a physical anchor effect to the substrate resin.

Further, the silane coupling agent layer of the surface-treated copper foil according to the present invention is preferably formed by using an amino-functional silane coupling agent or an epoxy-functional silane coupling agent.

Surface-treated Copper Foil With a very thin Primer Resin Layer According to the Present Invention: A surface-treated copper foil with a very thin primer resin layer according to the present invention is characterized by comprising a very thin primer resin layer having an equivalent thickness of 1 $\mu$m to 5 $\mu$m on a bonding surface to an insulating resin substrate of the surface-treated copper foil according to the present invention as defined in the claims.

Further, the very thin primer resin layer is preferably formed by using resin composition comprising 5 parts by weight to 50 parts by weight of an epoxy resin (including a curing agent), 50 parts by weight to 95 parts by weight of a polyether sulfone which is soluble in a solvent, and an optionally-added curing accelerator in an amount required.

Further, the resin composition constituting the very thin primer resin layer of the surface-treated copper foil with a very thin primer resin layer according to the present invention is preferable to have a resin flow of 5% or less when measured according to descriptions in MIL-P-13949G of MIL specifications.

Method for Manufacturing a Surface-treated Copper Foil According to the Present Invention: A method for manufacturing a surface-treated copper foil according to the present inventions as defined in the claims comprising forming a nickel alloy layer on a bonding surface to an insulating resin substrate of an electro-deposited copper foil, forming a tin layer on the nickel alloy layer to finish a rust-proofing treatment layer, and forming a silane coupling agent layer by adsorbing a silane coupling agent on a surface of the tin layer followed by drying the silane coupling agent to finish the silane coupling agent layer, is **characterized in that** the solution in which the silane coupling agent is dispersed in water or an organic solvent to be a concentration of 0.5 g/L to 10 g/L is adsorbed on the surface of the tin layer and drying the solution to form the silane coupling agent layer.

Further, in the method for manufacturing a surface-treated copper foil according to the present invention, the drying is carried out to make a foil temperature of the electro-deposited copper foil to be 100°C to 200°C.

Method for Manufacturing a Surface-treated Copper Foil With a very thin Primer Resin Layer According to the Present Invention: A method for manufacturing the surface-treated copper foil with a very thin primer resin layer according to the present invention as defined in the claims is characterized by comprising the following steps a and b sequentially carried out to prepare a resin solution to be used in formation of the very thin primer resin layer, the resin solution is coated on a surface having a silane coupling agent layer formed on the copper foil in amount to form equivalent thickness of 1 μm to 5 μm, followed by drying to be a semi-cured state:

> step a: a resin composition is prepared by blending 5 parts by weight to 50 parts by weight of an epoxy resin (including a curing agent), 50 parts by weight to 95 parts by weight of a polyether sulfone which is soluble in a solvent, and an optionally-added curing accelerator in an amount required, and
> step b: a resin composition is dissolved by using an organic solvent to prepare a resin solution having a resin content of 10 wt% to 40 wt%.

Advantages of the Invention

The surface-treated copper foil according to the present invention comprises a rust-proofing treatment layer composed of a nickel alloy layer and tin layer stacked in this order. A surface-treated copper foil which comprises such a rust-proofing treatment layer satisfies the basic requirements such as the peel strength of the circuit in processing of the printed wiring board, the chemical resistance against to the peel loss, the moisture absorption resistance against to the peel loss, the solder blister and the like, without the use of chromium in the rust-proofing treatment layer of the electro-deposited copper foil. The surface-treated copper foil according to the present invention exhibits a performance equivalent to or higher than a conventional copper foil which has been subjected to a chromate treatment. Specifically, while the present specification merely describes a rust-proofing treatment layer, due to the presence of the rust-proofing treatment layer, adhesion properties such as peel strength on the substrate and chemical resistance against to the peel loss, are improved.

Furthermore, in the case of the rust-proofing treatment layer of the surface-treated copper foil according to the present invention, the copper foil exhibits good adhesion properties with substrate even without roughening treatment which gives an anchor effect to the substrate. Especially, by providing a very thin primer resin layer with an equivalent thickness of 1 μm to 5 μm on the bonding surface to the insulating resin substrate of the surface-treated copper foil according to the present invention, a good lamination with the substrate can be obtained.

In addition, the surface-treated copper foil according to the present invention is in a state in which a nickel alloy layer and a tin layer are stacked in order as a rust-proofing treatment layer. Therefore, the plating process can be carried out separately for the formation of the nickel alloy layer and the formation of the tin layer. Thus, there is no need to use a plating solution having poor solution stability, such as nickel-tin alloy plating, and there is no increase in management costs due to increased complexity of the process management.

Best Mode for Carrying Out the Invention

Embodiments relating to the surface-treated copper foil, the method for manufacturing the surface-treated copper foil, and the surface-treated copper foil with a very thin primer resin layer according to the present invention will be described.

<Surface-treated Copper Foil According to the Present Invention>

The surface-treated copper foil according to the present invention comprises a rust-proofing treatment layer and a silane coupling agent layer on a bonding surface of an electro-deposited copper foil to an insulating resin substrate, characterized in that the rust-proofing treatment layer is formed by stacking a nickel alloy layer composed of at least one selected from nickel-molybdenum, nickel-zinc, and nickel-molybdenum-cobalt having a thickness by weight of 5 mg/m$^2$ to 50 mg/m$^2$ and a tin layer having a thickness by weight of 5 mg/m$^2$ to 40 mg/m$^2$ in this order on the copper foil, the rust-proofing treatment layer has a total thickness by weight of a nickel alloy and tin of 10 mg/m$^2$ to 70 mg/m$^2$, the rust-proofing treatment layer has a ratio [nickel amount in the nickel alloy]/[tin amount] of 0.25 to 10, and the silane coupling agent layer is provided on a surface of the rust-proofing treatment layer. Here, "thickness by weight" is a value converted from the amount provided on unit surface area (1 m$^2$) determined by completely dissolving the rust-proofing treatment layer of a 5 x 5 cm size surface-treated copper foil in acid solution, and analyzing the solution with an ICP analyzer.

The surface-treated copper foil is characterized by employing a tin layer in the rust-proofing treatment layer. The tin layer is formed on the outermost layer of the rust-proofing treatment layer. Further, a silane coupling agent layer described below is provided on the surface of the tin layer. The combination of a tin layer and a silane coupling agent layer performs a very good benefits, fixing of the silane coupling agent is excellent and formed silane coupling agent layer is stable. When the tin layer is formed on the outermost layer of the rust-proofing treatment layer, the adhesion between the substrate resin and the surface-treated copper foil can be improved, and both the peel loss after immersing in a hydrochloric acid and peel loss after boiling described below can be improved.

However, when just the tin layer is provided on the electro-deposited copper foil, thermal diffusion between tin and the bulk copper may occur due to the heating and drying in manufacturing of the surface-treated copper foil, the heating in the manufacturing of the printed wiring board, and the like. Since thermal diffusion causes deviation of quality as a surface-treated copper foil, the nickel alloy layer is provided as a diffusion barrier layer. Therefore, by employing the rust-proofing treatment layer composed of the nickel alloy layer and the tin layer, heat resistance properties can be improved together with obtaining excellent adhesion properties with the substrate resin, without using a chromium component in the rust-proofing treatment layer.

Further, when a two layers structure for the rust-proofing treatment layer composed of a nickel alloy layer and a tin layer is employed, the thicknesses for nickel alloy layer and the tin layer can be arranged independently to make production stability excellent, and make management of the layer thicknesses easy. As a result, a composition which shows a good etching factor and/or a composition which makes sure migration resistance can be adjusted freely.

The electro-deposited copper foil subjected to the surface treatment will be described to make understanding of the embodiments easy. In the following description of the present specification, an electro-deposited copper foil is specified as the copper foil before forming of the rust-proofing treatment layer. Therefore, the electro-deposited copper foil is a concept which includes both an electro-deposited copper foil with and without roughening treatment. Either of these types may be used depending on the intended use.

The roughening treatment may be carried out by the methods either of performing putting of a fine metal particles or performing etching to the surface of a drum foil obtained by electrolyzing a copper electrolytic solution. Surface with uneven portions obtained by carrying out a roughening treatment on the bonding surface of the electro-deposited copper foil performs a physical anchor effect to the substrate resin. Here, as the former method in which fine metal particles are formed and put, the method in which copper fine particles are put on a matte side will be exemplified. The roughening treatment is composed of steps, a deposition step to put fine copper particles onto a matte side of the electro-deposited copper foil and a seal plating step to prevent these fine copper particles from falling off.

In the step of deposition to put fine copper particles on a matte side of the electro-deposited copper foil, burning plating conditions are employed as the electrolysis conditions. Therefore, the solution concentration generally used in the step of deposition to put fine copper particles is a lower concentration so that the burning plating conditions may be easily obtained. These burning plating conditions are not especially limited, and are determined considering the characteristics of the production line. For example, when a copper sulfate solution is applied, the conditions may be, a copper concentration of 5 g/L to 20 g/L, a sulfuric acid concentration of 50 g/L to 200 g/L, including other optional additives ($\alpha$-naphthoquinoline, dextrin, glue, thiourea and the like), a solution temperature of 15°C to 40°C, and a current density of 10 A/dm$^2$ to 50 A/dm$^2$.

The seal plating step for preventing the fine copper particles from falling off is a step for uniformly depositing the copper so that the fine copper particles are covered by level plating conditions in this order to prevent the deposited and put fine copper particles from falling off. Therefore, here the same solution as the bath used for forming of the bulk copper may be used as the copper ion supply source. These level plating conditions are not especially limited, and are determined considering the characteristics of the production line. For example, when a copper sulfate solution is used, the conditions may be, a copper concentration of 50 g/L to 80 g/L, a sulfuric acid concentration of 50 g/L to 150 g/L, a solution temperature of 40°C to 50°C, and a current density of 10 A/dm$^2$ to 50 A/dm$^2$. The roughening treatment is carried out in such manner on the surface of the electro-deposited copper foil (i.e. drum foil).

Next, the nickel alloy layer constituting the rust-proofing treatment layer is composed of at least one selected from nickel-molybdenum, nickel-zinc, and nickel-molybdenum-cobalt. When the rust-proofing treatment layer is formed by these nickel alloys, good rust-proofing effects can be obtained. The nickel alloy layer preferably constitutes the rust-proofing treatment layer with a thickness by weight of 5 mg/m$^2$ to 50 mg/m$^2$, and includes 10 wt% or more of nickel. However, the thickness of the nickel alloy layer of less than 5 mg/m$^2$ cannot satisfy its role as a diffusion barrier, and the meaning of providing the nickel alloy layer may expire. On the other hand, even when the calories given in heating of the printed wiring board processing may be considered, a thickness of the nickel alloy layer is not required to be more than 50 mg/m$^2$. It should be noted that the nickel alloy layer could have a thickness of more than 50 mg/m$^2$. Even when the nickel alloy layer remains on the substrate after the copper etching, the nickel alloy layer can be subsequently removed using a nickel alloy selective etching solution which dissolves just a nickel alloy without dissolving a copper. This is because, disregarding cost considerations, and there are no problems in terms of printed wiring board production.

The tin layer formed on the surface of the nickel alloy layer has a thickness by weight of 5 mg/m$^2$ to 40 mg/m$^2$. Combination of the tin layer and the silane coupling agent layer which will be described later performs good adhesion properties to the substrate resin. When the thickness by weight of a tin layer is less than 5 mg/m$^2$, how the silane coupling agent layer is formed on the tin layer, the peel strength as-received may be made good supported by an anchor effect caused by the roughening treatment, but chemical resistance against to the peel loss, humidity resistance against to the peel loss and the like might be poor. Especially, in the case the tin layer is formed by a plating method, it is difficult to obtain even thickness in the order of nanometers by an electro-plating method. However, the desired performance may be obtained as long as the thickness by weight of tin is at minimum 5 mg/m$^2$. In contrast, when the thickness by weight of the tin layer is more than 40 mg/m$^2$, the tin layer is too thick to fail the etching performance in manufacturing of the printed wiring board.

Further, the rust-proofing treatment layer having a two layers structure of the nickel alloy and the tin of the surface-treated copper foil according to the present invention has a total thickness by weight of the nickel alloy and tin of 10 mg/m$^2$ to 70 mg/m$^2$. The total thickness by weight represents the total thickness as a rust-proofing treatment layer. When the total thickness by weight of the nickel alloy and tin is more than 70 mg/m$^2$, the nickel alloy or tin metal components tend to remain as an etching residue among the patterned circuit boards when etched by using an acidic etching solution, such as a copper chloride etching solution or an iron chloride etching solution. As a result, chemical deposition of metal on the printed circuit boards in an electro-less plating process performed after etching and/or surface migration which makes short circuit in the operation may tend to occur. Further, the phenomenon so-called "blackening" may occur when an alkaline etching solution is used, so it is not preferable. On the other hand, when the total thickness by weight of the nickel alloy and tin is less than 10 mg/m$^2$, the respective thickness by weight of the nickel alloy and/or the tin are less than 5 mg/m$^2$. As a result, performance in rust-proofing may not be enough to fail long-term shelf life. It means that the object of the present invention to perform the quality of a copper foil as a chromium-free electronic material may be hardly achieved. Further, it is more preferable that the total thickness by weight of the nickel alloy and tin is 15 mg/m$^2$ to 45 mg/m$^2$. When the total thickness by weight is managed in the range, etching residue may not occur regardless of the used etching solution and reliable etching and removal of the rust-proofing treatment layer may be achieved. In addition, sufficient rust-proofing effects can be obtained and result stable total quality of a chromium-free copper foil as the material for electric use.

Further, in the rust-proofing treatment layer having a two layers structure of the nickel alloy and the tin of the surface-treated copper foil according to the present invention, the ratio [nickel amount in the nickel alloy]/[tin amount] is 0.25 to 10. When the ratio is less than 0.25, the nickel alloy content against to the tin content is too low to satisfy the property, the peel strength of the copper clad laminate after heating for about 60 minutes at 180°C. In contrast, when the ratio exceed 10, increase of the nickel alloy content against to the tin content may make the amount of the nickel alloy on the surface of the rust-proofing treatment layer excess to fail the fixing of the silane coupling agent, and it may result poor performance of the silane coupling agent as an adhesion properties improver. More preferable ratio for [nickel amount in the nickel alloy] / [tin amount] is 0.5 to 4. This is because that the various properties, peel strength and the like, are made remarkably stable even if not only a certain deviations may happen in the production processes but also the substrate is hot pressed and post heating is carried out. It is because that the adsorption of the silane coupling agent is stabilized also. As long as the similar effects can be obtained based on the technical concept of the present invention, it is obvious that the rust-proofing treatment layer may include unavoidable impurities. Further, to improve etchability of the nickel alloy layer and/or the tin layer by the copper etching solution, a certain amount of a component such as zinc and the like which can be easily etched may also be included as long as the similar performance can be maintained.

In strictly speaking, the rust-proofing treatment layer is preferable to be also provided on the opposite surface of the above-described rust-proofing treatment layer (nickel alloy layer/tin layer) of the surface-treated copper foil according to the present invention. In such a case, to assure long-term shelf life, prevent oxidation in the hot pressing, and assure black-oxide treatment ability, it is preferable to form a rust-proofing treatment layer including zinc on the opposite surface.

Further, the silane coupling agent layer may be formed by using a silane coupling agents such as an epoxy-functional silane, an amino-functional silane, a methacryloxy-functional silane, and a mercapto-functional silane and a like. In addition, a mixture of two or more selected from these silane coupling agents may be used. Among them, it is preferable to choose an amino-functional silane coupling agent or an epoxy-functional silane coupling agent.

The amino-functional silane coupling agent is selected from the group consisting of N-(2-aminoethyl)-3-aminopropyltrimethoxysilane, 3-(N-styrylmethyl-2-aminoethylamino)propyltrimethoxysilane, 3-aminopropyltriethoxysilane, bis(2-hydroxyethyl)-3-aminopropyltriethoxysilane, aminopropyltrimethoxysilane, N-methylaminopropyltrimethoxysilane, N-phenylaminopropyltrimethoxysilane, N-(3-acryloxy-2-hydroxypropyl)-3-aminopropyltriethoxysilane, 4-aminobutyltriethoxysilane, (aminoethylaminomethyl)phenethyltrimethoxysilane, N-(2-aminoethyl-3-aminopropyl)trimethoxysilane, N-(2-aminoethyl-3-aminopropyl)tris(2-ethylhexoxy)silane, 6-(aminohexylaminopropyl)trimethoxysilane, aminophenyltrimethoxysilane, 3-(1-aminopropoxy)-3,3-dimethyl-1-propenyltrimethoxysilane, 3-aminopropyltris(methoxyethoxyethoxy)silane, 3-aminopropyltriethoxysilane, 3-aminopropyltrimethoxysilane, w-aminoundecyltrimethoxysilane, 3-(2-N-benzylaminoethylaminopropyl)trimethoxysilane, bis(2-hydroxyethyl)-3-aminopropyltriethoxysilane, (N,N-diethyl-3-aminopropyl)trimethoxysilane, (N,N-dimethyl-3-aminopropyl)trimethoxysilane, N-methylaminopropyltrimethoxysilane, N-phenylaminopropyltrimethoxysilane, and 3-(N-styrylmethyl-2-aminoethylamino)propyltrimethoxysilane.

Further, the silane coupling agent layer in amount of silicon atoms is preferable to be provided in the range of 0.15 $mg/m^2$ to 20 $mg/m^2$, and more preferably 0.3 $mg/m^2$ to 2.0 $mg/m^2$. When the thickness by weight (in terms of silicon atoms) of the silane coupling agent layer is less than 0.15 $mg/m^2$, the adhesion between the substrate resin and the surface-treated copper foil may not be improved. On the other hand, the thickness by weight (in terms of silicon atoms) of the silane coupling agent layer may exceed 20 $mg/m^2$, but the adhesion may not be further improved even the silane coupling agent layer is thick.

<Method for Manufacturing the Surface-treated Copper Foil According to the Present Invention>

In the method for manufacturing the surface-treated copper foil according to the present invention comprises forming of a nickel alloy layer on a bonding surface to an insulating resin substrate of an electro-deposited copper foil, forming of a tin layer on the nickel alloy layer to finish a rust-proofing treatment layer, and forming of a silane coupling agent layer by adsorbing a silane coupling agent on a surface of the tin layer and drying of the silane coupling agent. And it is preferable to use the following nickel alloy electrolytic solution and electrolysis conditions for the nickel alloy layer formation.

Nickel Alloy Electrolytic Solution

$NiSO_4 \cdot 6H_2O$: (as Ni) 1 g/L to 10 g/L
$K_4P_2O_7$ Concentration: 50 g/L to 400 g/L

Electrolysis Conditions

Solution Temperature: 20°C to 50°C
pH: 9 to 12
Current Density: 0.1 $A/dm^2$ to 2.5 $A/dm^2$

For the nickel alloy electrolytic solution, a wide variety of solutions which are used popularly as nickel alloy plating solutions may be used. For example, i) using nickel sulfate under conditions of a nickel concentration of 5 g/L to 30 g/L, a solution temperature of 20°C to 50°C, a pH of 2 to 4, and a current density of 0.3 $A/dm^2$ to 10 $A/dm^2$; ii) using nickel sulfate under conditions of a nickel concentration of 1 g/L to 10 g/L, 50 g/L to 400 g/L potassium pyrophosphate, a solution temperature of 20°C to 50°C, a pH of 9 to 12, and a current density of 0.1 $A/dm^2$ to 2.5 $A/dm^2$; and iii) using nickel sulfate under conditions of a nickel concentration of 10 g/L to 70 g/L, 20 g/L to 60 g/L boric acid, a solution temperature of 20°C to 50°C, a pH of 2 to 4, and a current density of 1 $A/dm^2$ to 50 $A/dm^2$, as well as popular Watt bath conditions.

Among these, it is preferable to apply a solution composition in which nickel sulfate hexahydrate and potassium pyrophosphate are included. Here, a concentration of the nickel sulfate hexahydrate is preferable to be as nickel of 1 g/L to 10 g/L. When a concentration of the nickel is less than 1 g/L, a concentration of the nickel in the plating solution is too low and it makes the current efficiency poor. As a result, not only fail to satisfy industrial productivity, but also make smoothness of the plating surface poor with cosmetic defects caused by gas generation. Further, when a concentration of the nickel exceed 10 g/L, the ratio between the nickel ions and the complex forming component (i.e., the P ratio) decreases and result poor evenness in electro-deposition.

The solution temperature of the electrolytic solution may be within a wide range of 20°C to 50°C. This is because there is less deviations in the physical properties when compared to a typical bath comprising nickel acetate or sulfamic acid. Further, with a solution having the above-described composition, a pH of 9 to 12 enables to obtain a plated layer having the most stable quality. In addition, the current density for plating may be within a range of 0.1 $A/dm^2$ to 2.5

A/dm$^2$. This is because there are fewer fluctuations in the quality of the nickel alloy layer from the current density when compared to a nickel acetate bath. The above-described contents are performed with bath agitation to make the plating solution moving.

Next, it is preferable to apply the composition for tin electrolytic solution and the condition for electrolysis described below for forming of the tin layer of the surface-treated copper foil.

Tin Electrolytic Solution

K$_2$SnO$_3$·3H$_2$O: (as the tin) 1 g/L to 10 g/L
K$_4$P$_2$O$_7$ Concentration: 50 g/L to 400 g/L

Electrolysis Conditions

Solution Temperature: 20°C to 45°C
pH: 10 to 13
Current Density: 0.1 A/dm$^2$ to 2.0 A/dm$^2$

In addition, for the tin electrolytic solution, a solution which is used popularly as a tin plating solution may be used. For example, various solutions may be used, such as stannous sulfate under conditions of a tin concentration of 2 g/L to 15 g/L, a solution temperature of 20°C to 50°C, a pH of 2 to 4, and a current density of 0.3 A/dm$^2$ to 10 A/dm$^2$. Among such solutions, it is preferable to use a tin electrolytic solution with a potassium stannate trihydrate concentration (as the tin) of 1 g/L to 10 g/L and a potassium pyrophosphate concentration of 50 g/L to 400 g/L, under conditions of a solution temperature of 20°C to 45°C, a pH of 10 to 13, and a current density of 0.1 A/dm$^2$ to 2.0 A/dm$^2$. As for the pH of the tin plating solution, to prevent generation of a tin oxide sludge, the pH is strongly preferred to be 11.5 or less. Further, the pH in the tin plating solution fluctuates depending on conditions such as the tin ion concentration, the current density and the solution temperature. And when the pH is below 10.5, the generation of hydrogen gas in the plating operation becomes remarkable to result difficulty in the formation of a uniform plating layer. Therefore, it is preferable to control the pH within 10.5 to 11.5. To assure plating uniformity of the tin layer, it is preferable to apply the composition for a tin electrolytic solution and the electrolysis conditions described above. Therefore, when the operation is carried out beyond the above-described composition range and electrolysis conditions, uniformity in the thickness of tin layer may be lost.

The silane coupling agent layer formed on the surface of the above-described rust-proofing treatment layer is preferably formed in the following manner. An amino-functional silane coupling agent or an epoxy-functional silane coupling agent is dissolved in the solvent, water or organic solvent to be a concentration of 0.5 g/L to 10 g/L. Thus obtained solution at room temperature is scattered on the surface of the tin layer to be adsorbed, and then dried to form the silane coupling agent layer. As the silane coupling agent layer is formed by a condensation reaction with an OH group on the rust-proofing treatment layer, even when a solution having an unnecessarily high concentration is used, increase in the effects may be not remarkable. When the concentration is less than 0.5 g/L, the adsorption rate of the silane coupling agent is too slow not to satisfy a commercial performance, and uniform adsorption may not be achieved also. Further, when the concentration exceed 10 g/L, polymerization of the coupling agent may happen easy to make the solution tends to be an emulsion, and the deviation of performance may increases also. Therefore, to obtain a suitable adsorption rate of the silane coupling agent together with preventing polymerization of the silane coupling agent, the silane coupling agent concentration is more preferable to be 3 g/L to 6 g/L.

After finishing the silane coupling agent adsorption treatment, drying is carried out by elevating the temperature of an electro-deposited copper foil to 100°C to 200°C. For example, a drying treatment is carried out in the atmosphere at a temperature of 160°C to 250°C, and more preferably 170°C to 200°C. Here, what is most important is not temperature of the atmosphere, but the elevated temperature of the foil itself. For economic reasons, it is preferred to efficiently elevate the temperature of the foil by a high-temperature with short time treatment utilizing hot air or the like. When the temperature of the foil in drying is less than 100°C, the moisture may disappear, but a condensation reaction between the adsorbed silane coupling agent and an OH group on the surface of the rust-proofing treatment layer may not promoted. In addition, the moisture generated in a condensation reaction cannot be evaporated within a short period of time. On the other hand, when the temperature of the foil in drying excess 200°C, a risk for decomposition and/or degrading of the functional groups in the silane coupling agent which should bond with the resin constituting the substrate may be arose, so it is not preferable. If the functional groups participating in the adhesion of the silane coupling agent with the substrate resin are decomposed and/or degraded, the adhesion properties between the copper foil and the substrate are made poor, so that the effects of the adsorption of the silane coupling agent cannot be fully performed. Further, an electric heater or a hot air blowing may be utilized for drying. However, in the case of an air blowing, since the temperature of the foil itself is elevated in shorter time than the temperature of the air blown on the copper foil, it is preferred to strictly manage and adjust the atmosphere temperature. Here, the foil temperature of the electro-deposited copper foil is specified according to a drying test which is carried out on an electro-deposited copper foil attached with a temperature detection label, and the foil temperatures in the drying treatment are investigated to determine preferable temperature. Specifically, a Thermolabel 5E (manufactured by Nichiyu Giken Kogyo Co., Ltd.), which is an irreversible temperature detection label, is directly attached on the copper foil, and the foil showered with the silane coupling agent is put in the furnace circulating a hot air. The foil temperature is confirmed by investigating the temperature detection label after finishing drying test.

<Surface-treated Copper Foil with Very Thin Primer Resin Layer According to the Present Invention>

The surface-treated copper foil with a very thin primer resin layer according to the present invention comprises a very thin primer resin layer with an equivalent thickness of 1 $\mu$m to 5 $\mu$m on the bonding surface to the insulating resin substrate of the surface-treated copper foil according to the present invention. Here, as for the surface-treated copper foil, the bonding surface may be whether the shiny side or the matte side of the electro-deposited copper foil. It is especially utilized when these surfaces are not subjected to a roughening treatment.

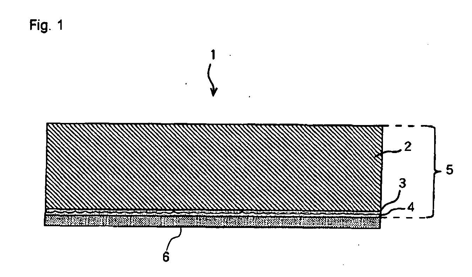

A surface-treated copper foil with a very thin primer resin layer 1 according to the present invention has a cross-sectional construction as schematically shown in Figure 1. In Figure 1, a rust-proofing treatment layer 3 on a copper foil 2 and a silane coupling agent layer 4 are clearly illustrated, but in an actual products, the silane coupling agent layer 4 is especially hard to confirm as a layer completely even when a transmission electron microscope is used. It means that these parts have been clearly illustrated to make understanding of the following descriptions easy. In the simplest speaking, the surface-treated copper foil with a very thin primer resin layer 1 according to the present invention is a surface-treated copper foil 5 which comprises a very thin resin layer on one surface without roughening treatment. In the case of the surface-treated copper foil with a very thin primer resin layer according to the present invention, the very thin resin layer is called a "very thin primer resin layer 6".

By the way, as the surface-treated copper foil according to the present invention comprises the very thin primer resin layer 6 with an equivalent thickness of 1 $\mu$m to 5 $\mu$m on the rust-proofing treatment layer 3 and silane coupling agent layer 4, good adhesion with the substrate resin can be obtained even without a roughening treatment on the surface-treated copper foil. It means that when compared to the case a surface-treated copper foil without roughening treatment is directly laminated on a substrate resin, adhesion with the substrate resin is dramatically improved by effect obtained by utilizing the very thin primer resin layer.

The very thin primer resin layer is a very thin resin layer with a thickness of 1 $\mu$m to 5 $\mu$m. The reason why to apply such a thin resin layer is to reduce resin flow of the surface-treated copper foil with a very thin primer resin layer according to the present invention in hot pressing to laminate with a resin substrate such as a prepreg. In conventional lamination of a surface-treated copper foil and a resin substrate, uneven portions exist on the roughened surface of the surface-treated copper foil, and air is trapped in a gap between the surface-treated copper foil and the resin substrate. A resin is made to flow in about 5 mm to 15 mm from the edges of a 1 m$^2$ size copper clad laminate to remove the air. In contrast, in the surface-treated copper foil with a very thin primer resin layer according to the present invention, requirement on less resin flow is the most important factor to assure good adhesion with the substrate resin even for the surface-treated copper foil without roughening treatment.

In the present specification, the resin flow is determined as the value when measured according to MIL specification disclosed in MIL-P-13949G. Specifically, four 10 cm-square specimens taken from the surface-treated copper foil with a very thin primer resin layer according to the present invention are stacked and laminated each other at a press temperature of 171°C, a press pressure of 14 kgf/cm$^2$, and a press time of 10 minutes. The resin flow of the sample is calculated according to expression 1. However, sensitivity in the measurement accuracy cannot be obtained when the surface-treated copper foil with a very thin primer resin layer according to the present invention is used as it is. So, the measurement of the resin flow in the present specification is performed by using experimentally prepared 40 $\mu$m-thick resin layers on the specimens practically. It can be noted that the resin flows of a popular prepreg and a popular resin coated copper foil (40 $\mu$m-thick resin layer) are about 20%.

[Expression 1]

$$\text{Resin Flow (\%)} = \frac{\text{Weight of Flood Resin}}{(\text{Laminate Weight}) - (\text{Copper Weight})} \times 100$$

When thickness of the very thin primer resin layer is less than 1 $\mu$m, no matter how the surface-treated copper foil comprises the surface which is smooth and free from uneven portions, it is difficult to coat at a uniform thickness. Further, it is more preferable for the very thin primer resin layer thickness to be a lower limit of 1 $\mu$m or more to make the covered surface more uniform on the surface-treated copper foil. In contrast, even when the thickness of the very thin primer resin layer is more than 5 $\mu$m, no big change may be observed in the adhesion properties with substrate or prepreg. However, no remarkable effects on improvement of adhesion properties may be obtained also and it may result just a waste of resources. It should be noted that the equivalent thickness is the value obtained by calculation from amount of the very thin primer resin layer coated on 1 m² of an ideal flat surface.

The resin composition constituting the very thin primer resin layer will be described. Simply stated, the resin composition used in the present invention is composed of an epoxy resin (including a curing agent), a polyether sulfone resin which is soluble in a solvent, and an optionally-added curing accelerator in an amount required.

The "epoxy resin" here is the epoxy resin which contains two or more epoxy-functional groups in the molecule, and it can be used without any particular problems as long as which is utilized in applications for electrical and electronic materials. Among these, it is preferable to use one kind or a mixture of two kinds or more selected from the group consisting of a bisphenol A type epoxy resin, a bisphenol F type epoxy resin, a bisphenol S type epoxy resin, a novolac type epoxy resin, a cresol novolac type epoxy resin, a cycloaliphatic epoxy resin, a brominated epoxy resin, a glycidyl amine type epoxy resin, and a phosphorous-containing epoxy resin.

The epoxy resin is a chief component of the resin composition, and is blended in proportion of 5 parts by weight to 50 parts by weight. However, the epoxy resin may be the material containing the curing agent which will be described later. Therefore, when the epoxy resin including the curing agent is less than 5 parts by weight, poor thermosetting performance may be obtained. As a result, the function as a binder with the substrate resin and the adhesion properties with the copper foil are not sufficiently performed. In contrast, when the epoxy resin is more than 50 parts by weight, balance with the amount of the polyether sulfone resin may not well, and fail to obtain sufficient toughness after curing.

Next, the "curing agent" of the epoxy resin is an amine such as a dicyandiamide, an imidazole, and an aromatic amine, a phenol such as bisphenol A and brominated bisphenol A, a novolac such as a phenol novolac resin and a cresol novolac resin, an acid anhydride such as a phthalic anhydride and the like. Since the amount of the curing agent against to amount of the epoxy resin contained should be determined according to the respective equivalent amounts. So, it may be not required to strictly specify the blending proportions. Therefore, in the present invention, the amount to be added of the curing agent is not limited.

The polyether sulfone resin is a resin which has a structure containing a hydroxyl-functional group or an amino-functional group on an end of the structure, and is soluble in a solvent. This is because if there is no hydroxyl-functional group or amino-functional group on an end of the structure, the reaction with the epoxy resin may not occur. In addition, if the polyether sulfone resin is not soluble in the solvent, solid content adjustment is made difficult. Further, when the balance with the epoxy resin is considered, the polyether sulfone resin is blended in proportion of 50 parts by weight to 95 parts by weight. By forming an insulating layer of a printed wiring board with the polyether sulfone resin, the water absorption in the insulating layer of the printed wiring board can be reduced, and deviation in the surface resistance of a printed wiring board can be decreased. When the polyether sulfone resin is less than 50 parts by weight, the resin may be easily damaged by the desmear treatment solution. On the other hand, if the polyether sulfone resin is more than 95 parts by weight, blistering in the solder blister test may happen by floating on a 260°C solder bath.

The "optionally-added curing accelerator in an amount required" is a phosphorous compound or a urea-based curing accelerator represented by a tertiary amine, an imidazole, and a triphenylphosphine. In the present invention, the blending proportion of the curing accelerator is not especially limited. The reason why is that the one skilled in the art may arbitrarily and selectively determine the amount of the curing accelerator to be added considering the productivity of the copper clad laminate production processes.

<Method for Manufacturing the Surface-treated Copper Foil with a Very Thin Primer Resin Layer>

The method for manufacturing the surface-treated copper foil with a very thin primer resin layer according to the above-described present invention will be described. The method employed is characterized in composed of steps a and b sequentially, i.e. preparing a resin solution to be used in formation of the very thin primer resin layer, coating the resin solution on a surface having a silane coupling agent layer formed on the copper foil to be equivalent thickness of 1 μm to 5 μm, followed by drying the solution to be a semi-cured state.

Preparation of the resin solution used in forming of the very thin primer resin layer will be described. In the step a, a resin composition is prepared by blending 5 parts by weight to 50 parts by weight of an epoxy resin (including a curing agent), 50 parts by weight to 95 parts by weight of a polyether sulfone which is soluble in a solvent, and an optionally-added curing accelerator in an amount required. As the compositions and blending proportions have already been respectively described, a description here may be repetitive, so, further descriptions will be omitted.

In the step b, the resin solution is prepared in the following manner. The polyether sulfone resin is dissolved in the solvent selected from one kind among dimethylformamide, dimethylacetamide, and N-methylpyrrolidone, or a mixture thereof to prepare a resin solution having a resin content of 10 wt% to 40 wt%. Specifically, it is more preferable to use a mixture of plurality of solvents to assure quality stability of the prepared resin solution for long-term. However, solvents not specifically mentioned here may also be used, as long as such a solvent can dissolve all of the resin components used in the present invention.

A binder resin solution having a resin content of 10 wt% to 40 wt% is prepared by using the solvent described above. The range of the resin content described here is a range which enables the accuracy of the coating thickness optimum when the binder resin solution is coated on the surface of the copper foil. When the resin content is less than 10 wt%, the viscosity of the resin solution is too low to cause flood of the binder resin solution just after coating on the copper foil surface, and it makes assurance of coating uniformity difficult. In contrast, when the resin content is more than 40 wt%, the viscosity of the resin solution is too high, and it results difficulty in formation of the thin coating on the copper foil surface.

As for coating method of the thus-obtained resin solution on the surface of the surface-treated copper foil with a silane coupling agent layer, the method is not especially limited. However, when the coating to be formed in good precision in an amount, an equivalent thickness of 1 $\mu$m to 5 $\mu$m is considered, it is preferable to use a so-called gravure coater which is well suitable for forming a thin coating. Further, the drying condition after forming the resin coating on the surface of the surface-treated copper foil may be selected from suitable heating conditions which can achieve a semi-cured state according to the characteristics of the resin solution.

[Example 1]

(Preparation of Surface-treated Copper Foil)

In Example 1, the surface of a matte side (surface roughness Ra = 0.64 $\mu$m, Rzjis = 3.0 $\mu$m) of an 18 $\mu$m-thick untreated electro-deposited copper foil (hereinafter, referred to as "drum foil") was subjected to a roughening treatment, a rust-proofing treatment, and a silane coupling agent treatment to prepare a surface-treated copper foil. In the Example 1, the rust-proofing treatment layer was composed of a nickel-molybdenum alloy layer and a tin layer. Details will be described in step by step.

Pickling Treatment: The above-described drum foil was subjected to acid pickling to clean the foil by removing oily components and a surface oxide on the surface, first. The acid pickling solution used contains a sulfuric acid with a concentration of 100 g/L. The drum foil was dipped for 30 seconds in the dilute sulfuric acid solution with a solution temperature of 30°C, and then rinsed by water.

Roughening Treatment: The cleaned drum foil was cathode-polarized in a copper sulfate solution with a sulfuric acid concentration of 150 g/L, a copper concentration of 14 g/L, and a solution temperature of 25°C, to deposit fine copper particles on the matte side by carrying out electrolysis for 5 seconds under burning plating conditions, a current density of 30 A/dm$^2$.

Next, to prevent the deposited fine copper particles from falling off, a seal plating was carried out to finish a roughened surface using a copper sulfate solution with a sulfuric acid concentration of 90 g/L, a copper concentration of 65 g/L, and a solution temperature of 45°C by carrying out electrolysis for 10 seconds under level plating conditions, a current density of 20 A/dm$^2$. The surface roughness after the roughening treatment was Ra of 0.71 $\mu$m and Rzjis of 4.4 $\mu$m.

Rust-proofing Treatment: In Example 1, a nickel-molybdenum alloy layer was formed on the surface of the matte side, and then a tin layer was formed thereon by using the nickel-molybdenum electrolytic solution and the tin electrolytic solution described later. The detailed production conditions for the formation of the nickel-molybdenum alloy layer and the tin layer are shown in Table 1. The nickel thickness by weight, the molybdenum thickness by weight, and the tin thickness by weight in the rust-proofing treatment layer of the prepared surface-treated copper foil were measured. The measurement results summarized are shown in Table 3. The thickness by weight shown in the examples and comparative examples were determined by preparing a solution by dissolving the rust-proofing treatment layer of the surface-treated copper foil which had been subjected to rust-proofing treatment, followed by analyzing of the solution using induction coupled plasma emission spectroscopy (ICP method) and converting the concentration to an amount of the components.

In the formation of the nickel-molybdenum alloy layer, the electrolysis was carried out by using the nickel-molybdenum alloy electrolytic solution, an aqueous solution containing 2.0 g/L (as nickel) of nickel sulfate hexahydrate, 0.8 g/L (as molybdenum) of disodium molybdate (VI) dihydrate, and 100 g/L of potassium pyrophosphate, at a solution temperature of 30°C, a pH of 10.3, and a current density of 0.66 A/dm$^2$ for 8 seconds in the bath without agitation to deposit an amount, the thickness by weight shown in Table 3.

In the formation of the tin layer, the electrolysis was carried out by using the tin electrolytic solution, an aqueous solution containing potassium stannate trihydrate with a concentration (as the tin) of 3 g/L and potassium pyrophosphate with a concentration of 100 g/L, at a solution temperature of 35°C, a pH of 11.0, and a current density of 0.66 A/dm$^2$ for 3 seconds to deposit an amount, the thickness by weight shown in Table 3.

Silane Coupling Agent Treatment: A silane coupling agent was adsorbed on the rust-proofing treatment layer of the above-described roughened surface. The solution composition was as following. $\gamma$-glycidoxypropyltrimethoxysilane was added to a deionized water as a solvent to have a concentration of 5 g/L. Then, the adsorption treatment was carried out by showering the solution.

After finishing silane coupling agent treatment, the foil was passed through a furnace having an atmosphere temperature adjusted in four seconds and heated to make the foil temperature of 140°C by using a hot air dryer. In such a manner, moisture is evaporated and a condensation reaction of the silane coupling agent is promoted to finish a surface-treated copper foil.

Preparation of a Circuit Board for Peel Strength Measurement: The roughened surface of the finished surface-treated copper foil was laminated with a 150 μm-thick FR-4 prepreg to prepare a copper clad laminate. Then, a dry film, which is an etching resist, was laminated on the surface-treated copper foil surface of the copper clad laminate, and a pattern for forming a test circuit was exposed and then developed. Next, respective straight circuits of 10 mm width, 0.8 mm width, and 0.2 mm width were formed by etching using a cupric chloride copper etching solution. These circuit board specimens were used for peel strength measurement. To ease comparison with the comparative examples, the results summarized for peel strength measurement are shown in Table 3. The methods for measuring the properties will be described.

The term "peel strength" in the present specification is the stress obtained when the copper foil circuit is peeled off from the substrate in a 90° direction (a perpendicular direction to the circuit board). Thereamong, the "peel strength as-received: P/S-A" is the peel strength measured after the circuits are prepared by the above-described etching without posttreatment. Next, the peel strength after solder floating is the peel strength after floating on the solder bath at 246°C for 20 seconds and measured at room temperature. When the peel strength qualifies 1.0 kgf/cm or more, it is said that a product is preferable in performance.

Next, the peel loss after immersing in a hydrochloric acid represents how the peel strength has lost in the prepared test circuits (the 0.8 mm width circuit and the 0.2 mm width circuit) after immersing the circuit in a hydrochloric acid (for the 0.2 mm width circuit, after immersing in a hydrochloric acid, HCl : water of 1 : 1 for 60 minutes at room temperature, and for the 0.8 mm width circuit, after immersing in a hydrochloric acid, HCl : water of 1 : 2 for 30 minutes at room temperature) shown in the respective tables from the P/S-A measured just after preparation. The peel loss after immersing in a hydrochloric acid is calculated by using the calculation formula shown in the following expression 2. When the peel loss after immersing in a hydrochloric acid is less than 10% for the 0.8 mm width circuit and less than 20% for the 0.2 mm width circuit, it is said that a product is preferable in performance.

**[Expression 2]**

$$\text{Peel loss after immersing in HCl soln. (\%)} = \frac{(P/S\text{-}A) - (\text{Peel strength after HCl immersion})}{(P/S\text{-}A)} \times 100$$

Next, the peel loss after boiling represents how the peel strength has lost in the prepared test circuit boards after the moisture absorption treatment (after boiling for 2 hours in deionized water) shown in the respective tables from the P/S-A measured just after preparation. The peel loss after boiling is calculated using the calculation formula shown in the following expression 3. It means that the smaller value of the peel loss is better in both the performance and the quality of the surface-treated copper foil. When the peel loss after boiling is less than 20% for the 0.8 mm width circuit, for example, it is said that a product is preferable in performance.

**[Expression 3]**

$$\text{Peel loss after boiling (\%)} = \frac{(P/S\text{-}A) - (\text{Peel strength after boiling})}{(P/S\text{-}A)} \times 100$$

[Example 2]

(Preparation of Surface-treated Copper Foil)

In Example 2, the surface of the matte side (surface roughness Ra = 0.64 μm, Rzjis = 3.0 μm) of the same 18 μm-thick drum foil as in Example 1 was subjected to a roughening treatment, a rust-proofing treatment, and a silane coupling agent treatment to prepare a surface-treated copper foil. In the Example 2, the rust-proofing treatment layer was composed of a nickel-zinc alloy layer and a tin layer. Details will be described in step by step. However, since the pickling treatment and the roughening treatment are the same as in Example 1, the descriptions thereof will be omitted.

Rust-Proofing Treatment: In Example 2, a nickel-zinc layer was formed on the surface of the above-described roughened surface, and then a tin layer was formed thereon by using the nickel-zinc electrolytic solution and the tin electrolytic solution described later. The detailed production conditions for the formation of the nickel-zinc alloy layer and the tin layer are shown in Table 1. The nickel thickness by weight, the zinc thickness by weight, and the tin thickness by weight on the roughened surface of the prepared surface-treated copper foil were measured. The measurement results summarized are shown in Table 3.

In the formation of the nickel-zinc alloy layer, the electrolysis was carried out by using the nickel-zinc alloy electrolytic solution, an aqueous solution of 2.5 g/L (as the nickel) nickel sulfate hexahydrate, 0.3 g/L (as the zinc) zinc pyrophosphate, and potassium pyrophosphate with a concentration of 100 g/L, at a solution temperature of 40°C, a pH of 9.85, and a current density of 0.66 A/dm$^2$ for 8 seconds in the bath with agitation.

In the formation of the tin layer, the electrolysis was carried out by using the tin electrolytic solution, an aqueous solution containing potassium stannate trihydrate with a concentration of 3 g/L (as the tin) and potassium pyrophosphate with a concentration of 100 g/L, at a solution temperature of 35°C, a pH of 11.0, and a current density of 0.66 A/dm$^2$ for 3 seconds to deposit an amount, the thickness by weight shown in Table 3.

Silane Coupling Agent Treatment: A silane coupling agent was adsorbed on the rust-proofing treatment layer of the roughened surface under the same conditions as in Example 1.

After finishing silane coupling agent treatment, the foil was passed through a furnace in four seconds having an atmosphere temperature adjusted and heated to make the foil temperature of 140°C by using a hot air dryer. In such a manner, moisture is evaporated and a condensation reaction of the silane coupling agent is promoted to finish a surface-treated copper foil.

Preparation of a Circuit Board for Peel Strength Measurement: The roughened surface of the finished surface-treated copper foil was laminated with a 150 $\mu$m-thick FR-4 prepreg to prepare a copper clad laminate. Then, respective straight circuits of 10 mm width, 0.8 mm width, and 0.2 mm width used for peel strength measurement were formed by same manner with the Example 1. The results summarized for peel strength measurement are shown in Table 3.


[Example 3]


(Preparation of Surface-treated Copper Foil)


In Example 3, the surface of the matte side (surface roughness Ra = 0.64 $\mu$m, Rzjis = 3.0 $\mu$m) of the same 18 $\mu$m-thick drum foil as in Example 1 was subjected to a roughening treatment, a rust-proofing treatment, and a silane coupling agent treatment to prepare a surface-treated copper foil. In the Example 3, the rust-proofing treatment layer was composed of a nickel-molybdenum-cobalt alloy layer and a tin layer. Details will be described in step by step. However, since the pickling treatment and the roughening treatment are the same as in Example 1, the descriptions thereof will be omitted.

Rust-Proofing Treatment: In Example 2, a nickel-molybdenum-cobalt layer was formed on the surface of the above-described roughened surface, and then a tin layer was formed thereon by using the nickel-molybdenum-cobalt electrolytic solution and the tin electrolytic solution described later. The detailed production conditions for the formation of the nickel-molybdenum-cobalt alloy layer and the tin layer are shown in Table 1. The nickel thickness by weight, the molybdenum thickness by weight, the cobalt thickness by weight, and the tin thickness by weight on the roughened surface of the prepared surface-treated copper foil were measured. The measurement results summarized are shown in Table 3.

In the formation of the nickel-molybdenum-cobalt alloy layer, the electrolysis was carried out by using the nickel-molybdenum-cobalt alloy electrolytic solution, an aqueous solution of 6.7 g/L (as the nickel)nickel sulfate hexahydrate, 1.2 g/L (as the molybdenum) disodium molybdate (VI) dihydrate, 1.5 g/L (as the cobalt) cobalt(II) sulfate hepta-hydrate, and tri-sodium citrate dihydrate with a concentration of 30 g/L, at a solution temperature of 30°C, a pH of 5.0, and a current density of 2 A/dm$^2$ for 4 seconds in the bath with agitation.

In the formation of the tin layer, the electrolysis was carried out by using the tin electrolytic solution, an aqueous solution containing potassium stannate trihydrate with a concentration of 3 g/L (as the tin) and potassium pyrophosphate with a concentration of 100 g/L, at a solution temperature of 35°C, a pH of 11.0, and a current density of 0.66 A/dm$^2$ for 3 seconds to deposit an amount, the thickness by weight shown in Table 3.

Silane Coupling Agent Treatment: A silane coupling agent was adsorbed on the rust-proofing treatment layer of the roughened surface under the same conditions as in Example 1.

After finishing silane coupling agent treatment, the foil was passed through a furnace having an atmosphere temperature adjusted in four seconds and heated to make the foil temperature of 140°C by using a hot air dryer. In such a manner, moisture is evaporated and a condensation reaction of the silane coupling agent is promoted to finish a surface-treated copper foil.

Preparation of a Circuit Board for Peel Strength Measurement: The roughened surface of the finished surface-treated copper foil was laminated with a 150 $\mu$m-thick FR-4 prepreg to prepare a copper clad laminate. Then, respective straight circuits of 10 mm width, 0.8 mm width, and 0.2 mm width used for peel strength measurement were formed by same manner with the Example 1. The results summarized for peel strength measurement are shown in Table 3.

[Example 4]

(Preparation of Surface-treated Copper Foil with Very Thin Primer Resin Layer)

In Example 4, the surface of the shiny side (surface roughness Ra = 0.25 $\mu$m, Rzjis = 1.2 $\mu$m) of an 18 $\mu$m-thick drum foil was subjected to a rust-proofing treatment and a silane coupling agent treatment, followed by forming of a very thin primer resin layer thereon to prepare a surface-treated copper foil with a very thin primer resin layer. In the Example 4, the rust-proofing treatment layer was composed of a nickel-molybdenum alloy layer and a tin layer. Specifically, the bonding surface to the insulating resin substrate of the surface-treated copper foil comprises a very thin primer resin layer. Details will be described in step by step.

Pickling treatment: The drum foil was subjected to acid pickling to clean the foil by removing oily components and a surface oxide film in the same manner as in Example 1.

Rust-proofing Treatment: The drum foil after finishing the pickling treatment was cathode-polarized to form a nickel-molybdenum alloy layer on the shiny side by using the nickel-molybdenum alloy electrolytic solution, followed by forming a tin layer thereon by using a tin electrolytic solution. The production conditions of the nickel-molybdenum alloy layer and the tin layer are the same as in Example 1, and are summarized as shown in Table 2. Further, the nickel thickness by weight, the molybdenum thickness by weight, and the tin thickness by weight of the shiny side of the prepared surface-treated copper foil with a very thin primer resin layer were measured. The measurement results summarized are shown in Table 3.

Silane Coupling Agent Treatment: A silane coupling agent was adsorbed on the rust-proofing treatment layer of the shiny side under the same conditions as in Example 1. After finishing silane coupling agent treatment, the foil was passed through a furnace having an atmosphere temperature adjusted in four seconds and heated to make the foil temperature of 140°C by using a hot air dryer. In such a manner, moisture is evaporated and a condensation reaction of the silane coupling agent is promoted to finish a surface-treated copper foil.

Formation of the Very thin Primer Resin Layer: A resin solution to constitute the very thin primer resin layer was prepared.

The raw materials used in the preparation of the resin solution were an epoxy resin (EPPN-502, manufactured by Nippon Kayaku Co., Ltd.) and a polyether sulfone resin (Sumika Excel PES-5003P, manufactured by Sumitomo Chemical Co., Ltd.). In addition, an imidazole (2E4MZ, manufactured by Shikoku Chemicals Corporation) was added as a curing accelerator in the raw materials to finish the resin composition.

Resin Composition

| | |
|---|---|
| Epoxy Resin: | 50 parts by weight |
| Polyether Sulfone Resin: | 50 parts by weight |
| Curing accelerator: | 1 part by weight |

The resin composition was made to be a resin solution in which resin content is adjusted to be 30 wt% by using dimethylformamide. On the surface of the surface-treated copper foil where the silane coupling agent layer was formed, the thus-prepared resin solution was coated by using a gravure coater. Then, to prepare the copper foil with a very thin primer resin layer, a drying treatment for 3 minutes in a 140°C heated atmosphere was carried out to finish a semi-cured 1.5 $\mu$m-thick very thin primer resin layer.

On the other hand, to measure resin flow, a resin coated copper foil having a primer resin layer thickness of 40 $\mu$m (hereinafter referred to as "sample for resin flow measurement") was prepared. Four 10 cm-square samples were prepared for resin flow measurement, and the resin flow was measured according to the above-described specification MIL-P-13949G. The value of the resin flow obtained was 1.4%.

Preparation of a Circuit Board for Peel Strength Measurement: The surface where the semi-cured 1.5 $\mu$m-thick very thin primer resin layer was formed in the surface-treated copper foil with a very thin primer resin layer was laminated with a 150 $\mu$m-thick FR-4 prepreg to prepare a copper clad laminate. Then, a dry film, which is an etching resist, was laminated on the surface-treated copper foil surface of the copper clad laminate, and a pattern for forming a test circuit was exposed and then developed. Next, respective straight circuits of 10 mm width, 0.8 mm width, and 0.2 mm width were formed by etching using a cupric chloride copper etching solution. These circuit board specimens were used for peel strength measurement.

Peel Strength Measurement Results: To ease comparison with the comparative examples, the results summarized for peel strength measurement on above described specimens are shown in Table 3. The methods for measuring the properties are the same as in Example 1.

[Example 5]

(Preparation of Surface-treated Copper Foil with Very thin Primer Resin Layer)

In Example 5, the surface of the shiny side (surface roughness Ra = 0.25 $\mu$m, Rzjis = 1.2 $\mu$m) of an 18 $\mu$m-thick drum foil was subjected to a rust-proofing treatment and a silane coupling agent treatment, followed by forming of a very thin primer resin layer thereon to prepare a surface-treated copper foil with a very thin primer resin layer. In the Example 5, the rust-proofing treatment layer was composed of a nickel-zinc alloy layer and a tin layer. Specifically, the surface-treated copper foil with a very thin primer resin layer comprises a very thin primer resin layer on the bonding surface to the insulating resin substrate of the surface-treated copper foil. Details will be described in step by step.

Pickling treatment: The drum foil was subjected to acid pickling to clean the foil by removing oily components and a surface oxide film in the same manner as in Example 1.

Rust-proofing Treatment: The drum foil after finishing the pickling treatment was cathode-polarized to form a nickel-zinc alloy layer on the shiny side and a tin layer thereon by using the nickel-zinc alloy electrolytic solution and the tin electrolytic solution. The conditions to form the nickel-zinc alloy layer and the tin layer were the same as in Example 2. These conditions summarized are shown in Table 2. The nickel thickness by weight, the zinc thickness by weight, and the tin thickness by weight on the shiny side of the prepared surface-treated copper foil were measured. The measurement results summarized are shown in Table 3.

Silane Coupling Agent Treatment: A silane coupling agent was adsorbed on the rust-proofing treatment layer on the shiny side under the same conditions as in Example 1. After finishing silane coupling agent treatment, the foil was passed through a furnace having an atmosphere temperature adjusted in four seconds and heated to make the foil temperature of 140°C by using a hot air dryer. In such a manner, moisture is evaporated and a condensation reaction of the silane coupling agent is promoted to finish a surface-treated copper foil.

Formation of the Very thin Primer Resin Layer: A resin solution to constitute the very thin primer resin layer was prepared. In the formation of the very thin primer resin layer, the same resin composition as in Example 4 was prepared. The resin composition was made to be a resin solution in which resin content is adjusted to be 30 wt% by using dimethylformamide to perform the same resin flow as in Example 4. On the surface of the surface-treated copper foil where the silane coupling agent layer was formed, the thus-prepared resin solution was coated by using a gravure coater. Then, to prepare the copper foil with a very thin primer resin layer, a drying treatment for 3 minutes in a 140°C heated atmosphere was carried out to finish a semi-cured 1.5 $\mu$m-thick very thin primer resin layer.

On the other hand, to measure resin flow, a sample for resin flow measurement was prepared. Four 10 cm-square samples were prepared for resin flow measurement, and the resin flow was measured according to the above-described specification MIL-P-13949G. The value of the resin flow obtained was 1.4%.

Preparation of a Circuit Board for Peel Strength Measurement: The surface where the semi-cured 1.5 $\mu$m-thick very thin primer resin layer was formed in the surface-treated copper foil with a very thin primer resin layer was laminated with a 150 $\mu$m-thick FR-4 prepreg to prepare a copper clad laminate. Then, a dry film, which is an etching resist, was laminated on the surface-treated copper foil surface of the copper clad laminate, and a pattern for forming a test circuit was exposed and then developed. Next, respective straight circuits of 10 mm width, 0.8 mm width, and 0.2 mm width were formed by etching using a cupric chloride copper etching solution. These circuit board specimens were used for peel strength measurement.

Peel Strength Measurement Results: To ease comparison with the comparative examples, the results summarized for peel strength measurement on above described specimens are shown in Table 3. The methods for measuring the properties are the same as in Example 1.

[Comparative Examples]

[Comparative Example 1]

In Comparative Example 1, the surface of a matte side (surface roughness Ra = 0.64 $\mu$m, Rzjis = 3.0 $\mu$m) of an 18 $\mu$m-thick drum foil same as in Example 1 was subjected to a roughening treatment, a rust-proofing treatment (a nickel-molybdenum alloy layer), and a silane coupling agent treatment to prepare a surface-treated copper foil.

Pickling treatment: The drum foil was subjected to acid pickling to clean the foil by removing oily components and a surface oxide film in the same manner as in Example 1.

Roughening Treatment: The roughening treatment was carried out in the same manner as in Example 1.

Rust-proofing Treatment: In the formation of the nickel-molybdenum alloy layer, the electrolysis was carried out by using the nickel-molybdenum alloy electrolytic solution, an aqueous solution containing 2.0 g/L (as nickel) of nickel sulfate hexahydrate, 0.8 g/L (as molybdenum) of disodium molybdate (VI) dihydrate, and 100 g/L of potassium pyrophosphate was used. The formation conditions of the nickel-molybdenum alloy layer are shown in Table 1. Further, the nickel amount and the molybdenum amount of the roughened surface of the prepared sample are shown in Table 3.

Silane Coupling Agent Treatment: A silane coupling agent was adsorbed on the rust-proofing treatment layer of the roughened surface under the same conditions as in Example 1. After finishing silane coupling agent treatment, the foil was passed through a furnace having an atmosphere temperature adjusted in four seconds and heated to make the foil temperature of 140°C by using a hot air dryer. In such a manner, moisture is evaporated and a condensation reaction of the silane coupling agent is promoted to finish a surface-treated copper foil.

Preparation of a Circuit Board for Peel Strength Measurement: The roughened surface of the finished surface-treated copper foil was laminated with a 150 μm-thick FR-4 prepreg to prepare a copper clad laminate. Then, respective straight circuits of 10 mm width, 0.8 mm width, and 0.2 mm width used for peel strength measurement were formed by same manner with the Example 1.

Peel Strength Measurement Results: The results summarized for peel strength measurement on above described specimens are shown in Table 3. The methods for measuring the properties are the same as in Example 1.

[Comparative Example 2]

In Comparative Example 2, the surface of a matte side (surface roughness Ra = 0.64 μm, Rzjis = 3.0 μm) of an 18 μm-thick drum foil same as in Example 1 was subjected to a roughening treatment, a rust-proofing treatment (a nickel-zinc alloy layer), and a silane coupling agent treatment to prepare a surface-treated copper foil.

Pickling treatment: The drum foil was subjected to acid pickling to clean the foil by removing oily components and a surface oxide film in the same manner as in Example 1.

Roughening Treatment: The roughening treatment was carried out in the same manner as in Example 1.

Rust-proofing Treatment: In the formation of the nickel-zinc alloy layer, the electrolysis was carried out by using the nickel-zinc alloy plating solution (composition: 2.5 g/L (as nickel) nickel sulfate hexahydrate, 0.3 g/L (as zinc), zinc pyrophosphate and 100 g/L potassium pyrophosphate) was used. The formation conditions of the nickel-zinc alloy layer are shown in Table 1. Further, the nickel amount and the zinc amount of the roughened surface of the prepared sample are shown in Table 3.

Silane Coupling Agent Treatment: A silane coupling agent was adsorbed on the rust-proofing treatment layer of the roughened surface under the same conditions as in Example 1. After finishing silane coupling agent treatment, the foil was passed through a furnace having an atmosphere temperature adjusted in four seconds and heated to make the foil temperature of 140°C by using a hot air dryer. In such a manner, moisture is evaporated and a condensation reaction of the silane coupling agent is promoted to finish a surface-treated copper foil.

Preparation of a Circuit Board for Peel Strength Measurement: The roughened surface of the finished surface-treated copper foil was laminated with a 150 μm-thick FR-4 prepreg to prepare a copper clad laminate. Then, respective straight circuits of 10 mm width, 0.8 mm width, and 0.2 mm width used for peel strength measurement were formed by same manner with the Example 1.

Peel Strength Measurement Results: The results summarized for peel strength measurement on above described specimens are shown in Table 3. The methods for measuring the properties are the same as in Example 1.

[Comparative Example 3]

In Comparative Example 3, the surface of a matte side (surface roughness Ra = 0.64 μm, Rzjis = 3.0 μm) of an 18 μm-thick drum foil same as in Example 1 was subjected to a roughening treatment, a rust-proofing treatment (a nickel-molybdenum-cobalt alloy layer), and a silane coupling agent treatment to prepare a surface-treated copper foil.

Pickling treatment: The drum foil was subjected to acid pickling to clean the foil by removing oily components and a surface oxide film in the same manner as in Example 1.

Roughening Treatment: The roughening treatment was carried out in the same manner as in Example 1.

Rust-proofing Treatment: In the formation of the nickel-molybdenum-cobalt alloy layer, the electrolysis was carried out by using the nickel-molybdenum-cobalt alloy plating solution (composition: 6.7 g/L (as the nickel) nickel sulfate hexahydrate, 1.2 g/L (as the molybdenum) disodium molybdate (VI) dihydrate, 1.5 g/L (as the cobalt) cobalt(II) sulfate hepta-hydrate, and 30 g/L tri-sodium citrate dihydrate) was used. The formation conditions of the nickel-molybdenum-cobalt alloy layer are shown in Table 1. Further, the nickel amount and the zinc amount of the roughened surface of the prepared sample are shown in Table 3.

Silane Coupling Agent Treatment: A silane coupling agent was adsorbed on the rust-proofing treatment layer of the roughened surface under the same conditions as in Example 1. After finishing silane coupling agent treatment, the foil was passed through a furnace having an atmosphere temperature adjusted in four seconds and heated to make the foil temperature of 140°C by using a hot air dryer. In such a manner, moisture is evaporated and a condensation reaction of the silane coupling agent is promoted to finish a surface-treated copper foil.

Preparation of a Circuit Board for Peel Strength Measurement: The roughened surface of the finished surface-treated copper foil was laminated with a 150 $\mu$m-thick FR-4 prepreg to prepare a copper clad laminate. Then, respective straight circuits of 10 mm width, 0.8 mm width, and 0.2 mm width used for peel strength measurement were formed by same manner with the Example 1.

Peel Strength Measurement Results: The results summarized for peel strength measurement on above described specimens are shown in Table 3. The methods for measuring the properties are the same as in Example 1.

[Comparative Example 4]

In Comparative Example 4, the surface of the shiny side (surface roughness Ra = 0.25 $\mu$m, Rzjis = 1.2 $\mu$m) of an 18 $\mu$m-thick drum foil same as in Example 4 was subjected to a rust-proofing treatment (nickel-molybdenum alloy layer) and a silane coupling agent treatment, followed by forming of a very thin primer resin layer thereon to prepare a surface-treated copper foil with a very thin primer resin layer. Details will be described in step by step.

Pickling treatment: The drum foil was subjected to acid pickling to clean the foil by removing oily components and a surface oxide film in the same manner as in Example 1.

Rust-proofing Treatment: The drum foil after finishing the pickling treatment was cathode-polarized to form a nickel-molybdenum alloy layer on the shiny side by using the nickel-molybdenum alloy electrolytic solution as same with the Example 1. These conditions for forming the nickel-molybdenum alloy layer are shown in Table 2.

Silane Coupling Agent Treatment: A silane coupling agent was adsorbed on the rust-proofing treatment layer of the shiny side under the same conditions as in Example 1. After finishing silane coupling agent treatment, the foil was passed through a furnace having an atmosphere temperature adjusted in four seconds and heated to make the foil temperature of 140°C by using a hot air dryer. In such a manner, moisture is evaporated and a condensation reaction of the silane coupling agent is promoted to finish a surface-treated copper foil.

Formation of the Very thin Primer Resin Layer: A resin solution to constitute the very thin primer resin layer was prepared. In the formation of the very thin primer resin layer, the same resin composition as in Example 4 was prepared. The resin composition was made to be a resin solution in which resin content is adjusted to be 30 wt% by using dimethylformamide to perform the same resin flow as in Example 4. On the surface of the surface-treated copper foil where the silane coupling agent layer was formed, the thus-prepared resin solution was coated by using a gravure coater. Then, to prepare the copper foil with a very thin primer resin layer, a drying treatment for 3 minutes in a 140°C heated atmosphere was carried out to finish a semi-cured 1.5 $\mu$m-thick very thin primer resin layer.

Preparation of a Circuit Board for Peel Strength Measurement: The surface where the semi-cured 1.5 $\mu$m-thick very thin primer resin layer was formed in the surface-treated copper foil with a very thin primer resin layer was laminated with a 150 $\mu$m-thick FR-4 prepreg to prepare a copper clad laminate. Then, a dry film, which is an etching resist, was laminated on the surface-treated copper foil surface of the copper clad laminate, and a pattern for forming a test circuit was exposed and then developed. Next, respective straight circuits of 10 mm width, 0.8 mm width, and 0.2 mm width were formed by etching using a cupric chloride copper etching solution. These circuit board specimens were used for peel strength measurement.

Peel Strength Measurement Results: To ease comparison with the comparative examples, the results summarized for peel strength measurement on above described specimens are shown in Table 3. The methods for measuring the properties are the same as in Example 1.

[Comparative Example 5]

In Comparative Example 5, the surface of the shiny side (surface roughness Ra = 0.25 $\mu$m, Rzjis = 1.2 $\mu$m) of an 18 $\mu$m-thick drum foil as in Example 4 was subjected to a rust-proofing treatment (nickel-zinc alloy layer) and a silane coupling agent treatment, followed by forming of a very thin primer resin layer thereon to prepare a surface-treated copper foil with a very thin primer resin layer. Details will be described in step by step.

Pickling treatment: The drum foil was subjected to acid pickling to clean the foil by removing oily components and a surface oxide film in the same manner as in Example 1.

Rust-proofing Treatment: The drum foil after finishing the pickling treatment was cathode-polarized to form a nickel-zinc alloy layer on the shiny side by using the nickel-zinc alloy electrolytic solution as same with the Example 2. These conditions for forming the nickel-zinc alloy layer are shown in Table 2.

Silane Coupling Agent Treatment: A silane coupling agent was adsorbed on the rust-proofing treatment layer of the shiny side under the same conditions as in Example 1. After finishing silane coupling agent treatment, the foil was passed through a furnace having an atmosphere temperature adjusted in four seconds and heated to make the foil temperature of 140°C by using a hot air dryer. In such a manner, moisture is evaporated and a condensation reaction of the silane coupling agent is promoted to finish a surface-treated copper foil.

Formation of the Very thin Primer Resin Layer: A resin solution to constitute the very thin primer resin layer was prepared. In the formation of the very thin primer resin layer, the same resin composition as in Example 4 was prepared. The resin composition was made to be a resin solution in which resin content is adjusted to be 30 wt% by using dimethylformamide to perform the same resin flow as in Example 4. On the surface of the surface-treated copper foil where the silane coupling agent layer was formed, the thus-prepared resin solution was coated by using a gravure coater. Then, to prepare the copper foil with a very thin primer resin layer, a drying treatment for 3 minutes in a 140°C heated atmosphere was carried out to finish a semi-cured 1.5 $\mu$m-thick very thin primer resin layer.

Preparation of a Circuit Board for Peel Strength Measurement: The surface where the semi-cured 1.5 $\mu$m-thick very thin primer resin layer was formed in the surface-treated copper foil with a very thin primer resin layer was laminated with a 150 $\mu$m-thick FR-4 prepreg to prepare a copper clad laminate. Then, a dry film, which is an etching resist, was laminated on the surface-treated copper foil surface of the copper clad laminate, and a pattern for forming a test circuit was exposed and then developed. Next, respective straight circuits of 10 mm width, 0.8 mm width, and 0.2 mm width were formed by etching using a cupric chloride copper etching solution. These circuit board specimens were used for peel strength measurement.

Peel Strength Measurement Results: To ease comparison with the comparative examples, the results summarized for peel strength measurement on above described specimens are shown in Table 3. The methods for measuring the properties are the same as in Example 1.

The examples and comparative examples will be compared. Table 1 and 2 summarize the preparation conditions of each sample.

[Table 1]

| | Rust-proofing | Roughening treatment | Treatment side | Electrolysis conditions (Bath Composition : metal concentration, bath temperature, current density, electrolysis time) | |
| --- | --- | --- | --- | --- | --- |
| | | | | Nickel alloy layer | Tin layer |
| Example 1 | (Ni-Mo)+Sn Layer | Yes | Matte side | $K_4P_2O_7$: 100 g/L, $NiSO_4 \cdot 6H_2O$ (as Ni) : 2.0 g/L, $Na_2MoO_4 \cdot 2H_2O$ (as Mo): 0.8 g/L, pH 10.3, 30°C, 0.66 A/dm$^2$, 8 seconds | $K_4P_2O_7$: 100 g/L, $K_2SnO_3 \cdot 3H_2O$ (as Sn); 3.0 g/L, pH 11.0, 35°C, 0.66 A/dm$^2$, 3 seconds |
| Example 2 | (Ni-Zn)+Sn Layer | | | $K_4P_2O_7$: 100 g/L, $NiSO_4 \cdot 6H_2O$ (as Ni) : 2.5 g/L, $Zn_2P_2O_7$ (as Zn): 0.3 g/L, pH 9.85, 40°C, 0.66 A/dm$^2$, 8 seconds | |
| Example 3 | (Ni-Mo-Co)+Sn Layer | | | $NiSO_4 \cdot 6H_2O$ (as Ni) : 6.7 g/L, $Na_2MoO_4 \cdot 2H_2O$ (as Mo) . 1.2 g/L $CoSO_4 \cdot 7H_2O$ (as Co): 1.5 g/L, $Na_3C_6H_5O_7 \cdot 2H_2O$: 30 g/L, pH 5, 30°C, 0.2 A/dm$^2$, 4 seconds | |

(continued)

|  | Rust-proofing | Roughening treatment | Treatment side | Electrolysis conditions (Bath Composition : metal concentration, bath temperature, current density, electrolysis time) | |
|---|---|---|---|---|---|
|  |  |  |  | Nickel alloy layer | Tin layer |
| Comparative Example 1 | Ni-Mo Alloy | Yes | Matte side | $K_4P_2O_7$: 100 g/L, $NiSO_4·6H_2O$ (as Ni): 2.0 g/L, $Na_2MoO_4·2H_2O$ (as Mo) : 0.8 g/L, pH 10.3, 30°C, 0.66 $A/dm^2$, 8 seconds $A/dm^2$ | - |
| Comparative Example 2 | Ni-Zn Alloy |  |  | $K_4P_2O_7$: 100 g/L, $NiSO_4·6H_2O$ (as Ni): 2.5 g/L, $Zn_2P_2O_7$ (as Zn): 0.3 g/L, pH 9.85, 40°C, 0.66 $A/dm^2$, 8 seconds | - |
| Comparative Example 3 | Ni-Mo-Co Alloy |  |  | $NiSO_4·6H_2O$ (as Ni) : 6.7 g/L, $Na_2MoO_4·2H_2O$ (as Mo) : 1.2 g/L $CoSO_4·7H_2O$ (as Co): 1.5 g/L, $Na_3C_6H_5O_7·2H_2O$: 30 g/L, pH 5, 30°C, 0.2 $A/dm^2$, 4 seconds | - |

[Table 2]

|  | Rust-proofing | Treatment side | Very thin primer resin layer | Electrolysis conditions (Bath composition : metal concentration, bath temperature, current density, electrolysis time) | |
|---|---|---|---|---|---|
|  |  |  |  | Nickel alloy layer | Tin layer |
| Example 4 | (Ni-Mo)+Sn Layer | Shiny side | Yes | $K_4P_2O_7$: 100 g/L, $NiSO_4·6H_2O$ (as Ni) 2.0 g/L, $Na_2MoO_4·2H_2O$ (as Mo) : 0.8 g/L, pH 10.3, 30°C, 0.66 $A/dm^2$, 8 seconds | $K_4P_2O_7$: 100 g/L, $K_2SnO_3·3H_2O$ (as Sn): 3.0 g/L, pH 11.0, 35°C, 0.66 $A/dm^2$, 3 seconds |
| Example 5 | (Ni-Zn)+Sn Layer |  |  | $K_4P_2O_7$: 100 g/L, $NiSO_4·6H_2O$ (as Ni) : 2.5 g/L, $Zn_2P_2O_7$ (as Zn): 0.3 g/L, pH 9.85, 40°C, 0.66 $A/dm^2$, 8 seconds |  |
| Comparative Example 4 | Ni-Mo Alloy |  |  | $K_4P_2O_7$: 100 g/L, $NiSO_4·6H_2O$ (as Ni): 2.0 g/L, $Na_2MoO_4·2H_2O$ (as Mo): 0.8 g/L, pH 10.3, 30°C, 0.66 $A/dm^2$, 8 seconds | - |
| Comparative Example 5 | Ni-Zn Alloy |  |  | $K_4P_2O_7$: 100 g/L, $NiSO_4·6H_2O$ (as Ni): 2.5 g/L, $Zn_2P_2O_7$ (as Zn): 0.3 g/L, pH 9.85, 40°C, 0.66 $A/dm^2$, 8 seconds | - |

[Table 3]

| | Rust-proofing | Deposited amount (mg/m²) | | | | | | Adhesion properties evaluation (Peel strength on a FR-4 copper clad laminate) | | | | |
|---|---|---|---|---|---|---|---|---|---|---|---|---|
| | | | | | | | | P/S-A (10 mm width circuit) | Peel strength after solder floating (10 mm width circuit) | Peel loss after immersing in a HCl soln. (0.8 mm width circuit) | Peel loss after immersing in a HCl soln. (0.2 mm width circuit) | Peel loss after boiling (0.8 mm width circuit) |
| | | Ni | Mo | Co | Zn | Sum of Ni alloy | Sn | Kgf/cm | | % | | |
| Example 1 | (Ni-Mo)+Sn Layer | 25 | 6 | - | - | 31 | 7 | 1.10 | 1.10 | 0 | 0 | 5 |
| Example 2 | (Ni-Zn)+Sn Layer | 18 | - | - | 5 | 22 | 24 | 1.15 | 1.14 | 0 | 0 | 3 |
| Example 3 | (Ni-Mo-Co)+Sn Layer | 25 | 8 | 16 | - | 49 | 5 | 1.14 | 1.14 | 2 | 8 | 5 |
| Example 4 | (Ni-Mo)+Sn Layer | 23 | 7 | - | - | 30 | 9 | 1.18 | 1.21 | 0 | 9 | 1 |
| Example 5 | (Ni-Zn)+Sn Layer | 20 | - | - | 6 | 26 | 16 | 1.14 | 1.13 | 0 | 0 | 1 |
| Comparative Example 1 | Ni-Mo Alloy | 30 | 7 | - | - | 37 | - | 1.09 | 1.09 | 2 | 9 | 34 |
| Comparative Example 2 | Ni-Zn Alloy | 34 | - | - | 10 | 45 | - | 1.19 | 1.14 | 5 | 15 | 23 |
| Comparative Example 3 | Ni-Mo-Co Alloy | 25 | 8 | 16 | - | 49 | - | 1.18 | 1.17 | 0 | 8 | 19 |
| Comparative Example 4 | Ni-Mo Alloy | 29 | 9 | - | - | 38 | - | 1.26 | 1.28 | 3 | 31 | 38 |
| Comparative Example 5 | Ni-Zn Alloy | 34 | - | - | 10 | 44 | - | 1.19 | 1.14 | 5 | 15 | 23 |

<Comparison between the Examples and the Comparative Examples>

Comparison between Examples 1 to 3 and Comparative Examples 1 to 3: The thickness by weight of the elements in a rust-proofing treatment of Examples 1 to 3 and Comparative Examples 1 to 3 and the evaluation results using the samples are shown in Table 3. First of all, all of the evaluation results relating to the adhesion properties for Examples 1 to 3 are within the range of the above-described suitable performance values as a product, so it can be said that the surface-treated copper foils have excellent adhesion performance.

On the other hand, for Comparative Examples 1 to 3, it should be clearly stated here that the values for Comparative Examples 1 to 3 are sufficient for the performance required for a printed wiring board except the peel loss after boiling. Further, as for the alloy plating of Comparative Examples 1 to 3, control of the composition in the deposited alloy layer within a certain range is difficult, and it may result increased production costs and management costs. In other words, although Comparative Examples 1 to 3 are preferable in terms of not containing chromium, but the production stability may be not enough when a large amount of products having stable quality should be supplied to the market.

With the background described above, Examples 1 to 3 and Comparative Examples 1 to 3 will be compared. At first, a peel strength as-received will be compared. Values for Comparative Examples 2 and 3 show stronger peel strength than Examples 1 to 3. However, the difference between the examples and the comparative examples are almost similar, within the level of deviation. Further, for peel strength after solder floating, values in the examples and the comparative examples are almost even. Next, for the peel loss after immersing in a hydrochloric acid in the 0.8 mm width circuit and the peel loss after immersing in a hydrochloric acid in the 0.2 mm width circuit, Examples 1 and 2 are much better than Comparative Examples 1 and 2. On the other hand, when Example 3 is compared with Comparative Example 3, peel loss after immersing in a hydrochloric acid are almost same for the 0.2 mm width circuit, but peel loss after immersing in a hydrochloric acid for the 0.8 mm width circuit, Example 3 is a little inferior than Comparative Example 3. However, both of the peel loss of 2.0% in the 0.8 mm width circuit after hydrochloric acid immersion and the peel loss of 8.0% in the 0.2 mm width circuit after hydrochloric acid immersion of Example 3 may be a good performance as the peel loss. Further, when the peel loss after boiling is investigated, all values are 5% or less in Examples 1 to 3, the peel losses are very small. In contrast, values of peel loss in Comparative Examples 1 to 3 are very large. Thus, properties of the surface-treated copper foils prepared in Comparative Examples 1 to 3 may be deteriorate after wet etching and are not suitable for use in a high-humidity environment. Generally speaking, the surface-treated copper foil according to the present invention is characterized by excellent in peel loss after both immersing in a hydrochloric acid and after boiling, and peel strength itself also.

Thus, when the performance of Examples 1 to 3 are investigated, it can be clearly understood that their quality as a product is stable and excellent in total balance even they employ a rust-proofing treatment layer without chromium. Moreover, since the nickel alloy layer and a tin layer of the surface-treated copper foils disclosed in Examples 1 to 3 are formed one by one, it makes control of the process easy and complication of management such as in nickel-tin alloy plating is reduced drastically.

<Comparison between Examples 4 and 5 and Comparative Examples 4 and 5: The thickness by weight of the rust-proofing treatment elements of the samples prepared in Examples 4 and 5 and Comparative Examples 4 and 5 and the evaluation results using the copper foil with a very thin primer resin layer are shown in Table 3.

First, Comparative Examples 4 and 5 will be investigated. It should be clearly stated here that the values shown in Comparative Examples 4 and 5 are sufficient for the performance required for a printed wiring board. However, as for the alloy plating of Comparative Examples 4 and 5, control of the composition of the deposited alloy layer in a certain range is difficult, and it may result increased production costs and management costs. In other words, although Comparative Examples 1 to 3 are preferable in terms of not containing chromium, the production stability may be not enough when a large amount of products having stable quality should be supplied to the market.

Further, in Comparative Example 4, which is the case that a very thin primer resin layer was applied for the surface-treated copper foil of Comparative Example 1, the results obtained were almost same with the descriptions above. Specifically, in the surface-treated copper foil with a very thin primer resin layer of Comparative Example 4, all of peel strength as-received of the 10 mm width circuit, peel strength after solder floating, and the peel loss after immersing in a hydrochloric acid in the 0.8 mm width circuit show a sufficient performance. However, the values of peel loss after immersing in a hydrochloric acid in the 0.2 mm width circuit and the peel loss after boiling are large. It can be said that prepared surface-treated copper foil with a very thin primer resin layer in Comparative Example 4 may be deteriorate after wet etching and is not suitable for use in a high-humidity environment.

With the background described above, performance of the copper foils with a very thin primer resin layer of Examples 4 and 5 will be investigated. Peel strength as-received and the peel strength after solder floating are similar level with those of Comparative Examples 4 and 5. However, the values of peel loss after immersing in a hydrochloric acid in the 0.8 mm width circuit are lower than those of Comparative Examples 4 and 5. Further, when the values of peel loss after immersing in a hydrochloric acid for the 0.2 mm width circuit are investigated, value in the Example 4 of 9% is also within a preferable range as a product as described above. Thus, when the performance of Examples 4 and 5 are investigated, it can be clearly understood that their quality as a product is stable and excellent in total balance even they employ a rust-proofing treatment layer without chromium. Moreover, since the nickel alloy layer and a tin layer of the surface-treated copper foils disclosed in Examples 4 and 5 are formed one by one, so, it makes control of the process easy and complication of management such as in nickel-tin alloy plating is reduced drastically.

Industrial Applicability

The surface-treated copper foil according to the present invention comprise a rust-proofing treatment layer without chromium (including chromate) constituted with a nickel alloy layer and a tin layer thereon stacked one by one. Further, since amount of the rust-proofing layer of the present surface-treated copper foil is in a suitable range conventionally used in the production of a popular printed wiring board, special equipment and/or process are not required. It means that even though a nickel alloy and tin are included in the rust-proofing elements, it is etchable by a popular copper etching solution. In addition, the surface-treated copper foil according to the present invention satisfies basic requirements, such as a peel strength, a chemical resistance against to the peel loss, a moisture absorption resistance against to the peel loss, a solder blistering and the like of the circuits after processed to be the printed wiring board, and has excellent quality stability.

Further, the rust-proofing treatment layer of the surface-treated copper foil according to the present invention performs good adhesion with substrate due to the provided very thin primer resin layer, even if the copper foil surface is not subjected to a roughening treatment which give an anchor effect to the substrate.

Brief Description of the Drawing

[Figure 1]

Figure 1 is a schematic cross-sectional view of a surface-treated copper foil with a very thin primer resin layer.

**Claims**

1. A chromium-free surface-treated copper foil (5) comprising a rust-proofing treatment layer (3) and a silane coupling agent layer (4) on a bonding surface of an electro-deposited copper foil (5) to an insulating resin substrate, **characterized in that**
the rust-proofing treatment layer (3) is formed by stacking a nickel alloy layer composed of at least one selected from nickel-molybdenum, nickel-zinc, and nickel-molybdenum-cobalt having a thickness by weight of 5 mg/m$^2$ to 50 mg/m$^2$ and a tin layer having a thickness by weight of 5 mg/m$^2$ to 40 mg/m$^2$ in this order on the copper foil, the rust-proofing treatment layer has a total thickness by weight of a nickel alloy and tin of 10 mg/m$^2$ to 70 mg/m$^2$, the rust-proofing treatment layer has a ratio [nickel amount in the nickel alloy]/[tin amount] of 0.25 to 10, and the silane coupling agent layer (4) is provided on a surface of the rust-proofing treatment layer (3).

2. The surface-treated copper foil according to claim 1, wherein the bonding surface of the electro-deposited copper foil (5) is subjected to a roughening treatment.

3. The surface-treated copper foil according to claim 1, wherein the silane coupling agent layer (4) is formed by using an amino-functional silane coupling agent or an epoxy-functional silane coupling agent.

4. A surface-treated copper foil with a very thin primer resin layer (6) **characterized by** comprising a very thin primer resin layer (6) having an equivalent thickness of 1 μm to 5 μm on a surface of the surface-treated copper foil (5) to be bonded to an insulating resin substrate according to claim 1.

5. The surface-treated copper foil with a very thin primer resin layer (6) according to claim 4, wherein the very thin primer resin layer (6) is formed by using the resin composition comprising 5 parts by weight to 50 parts by weight of an epoxy resin (including a curing agent), 50 parts by weight to 95 parts by weight of a polyether sulfone which is soluble in a solvent, and an optionally-added curing accelerator in an amount required.

6. The surface-treated copper foil with a very thin primer resin layer (6) according to claim 4, wherein a resin flow of the very thin primer resin layer (6) formed from the resin composition is 5% or less when measured according to disclosure in MIL-P-13949G of MIL Specifications.

7. A method for manufacturing a surface-treated copper foil (5) according to any one of claims 1 to 3, wherein the method comprises forming a nickel alloy layer on a bonding surface to an insulating resin substrate of an electro-deposited copper foil, forming a tin layer on the nickel alloy layer to finish a rust-proofing treatment layer (3), and forming a silane coupling agent layer (4) by adsorbing a silane coupling agent on a surface of the tin layer followed by drying the silane coupling agent to finish the silane coupling agent layer, **characterized in that**:

   a solution in which the silane coupling agent is dispersed in water or an organic solvent to be a concentration of 0.5 g/L to 10 g/L is adsorbed on the surface of the tin layer and drying the solution to form the silane coupling agent layer (4).

8. The method for manufacturing a surface-treated copper foil (5) according to claim 7, wherein the drying is carried out to make a foil temperature of the electro-deposited copper foil to be 100°C to 200°C.

9. A method for manufacturing the surface-treated copper foil (5) with a very thin primer resin layer (6) according to claim 4, **characterized by** comprising the following steps a and b are carried out sequentially to prepare a resin solution to be used in formation of the very thin primer resin layer (6), and the resin solution is coated on a surface having a silane coupling agent layer (4) formed on the copper foil in amount to form equivalent thickness of I $\mu$m to 5 $\mu$m, followed by drying to be a semi-cured state:

   step a: a resin composition is prepared by blending 5 parts by weight to 50 parts by weight of an epoxy resin (including a curing agent), 50 parts by weight to 95 parts by weight of a polyether sulfone which is soluble in a solvent, and an optionally-added curing accelerator in an amount required, and
   step b: the resin composition is dissolved by using an organic solvent to prepare a resin solution having a resin content of 10 wt% to 40 wt%.

**Patentansprüche**

1. Chromfreie oberflächenbehandelte Kupferfolie (5) umfassend eine Rostschutzbehandlungsschicht (3) und eine Silanhaftmittelschicht (4) auf einer Bindungsoberfläche einer elektrochemisch hergestellten Kupferfolie (5) an ein isolierendes Harzsubstrat, **dadurch gekennzeichnet, dass**
die Rostschutzbehandlungsschicht (3) ausgebildet ist durch übereinander Anordnen einer Nickellegierungsschicht bestehend aus wenigstens Nickel-Molybdän, Nickel-Zink oder Nickel-Molybdän-Kobalt mit einer Gewichtsstärke von 5 mg/m$^2$ bis 50 mg/m$^2$ und einer Zinnschicht mit einer Gewichtsstärke von 5 mg/m$^2$ bis 40 mg/m$^2$, in dieser Reihenfolge auf der Kupferfolie, wobei die Rostschutzbehandlungsschicht eine Gesamtgewichtsstärke aus einer Nickellegierung und Zinn von 10 mg/m$^2$ bis 70 mg/m$^2$ aufweist, die Rostschutzbehandlungsschicht ein Verhältnis [Nickelmenge in der Nickellegierung]/[Zinnmenge] von 0,25 bis 10 aufweist, und
die Silanhaftmittelschicht (4) auf einer Oberfläche der Rostschutzbehandlungsschicht (3) vorgesehen ist.

2. Oberflächenbehandelte Kupferfolie nach Anspruch 1, wobei die Bindungsoberfläche der elektrochemisch hergestellten Kupferfolie (5) einer Aufraubehandlung unterzogen ist.

3. Oberflächenbehandelte Kupferfolie nach Anspruch 1, wobei die Silanhaftmittelschicht (4) unter Verwendung eines Amino-funktionellen Silanhaftmittels oder eines Epoxyfunktionellen Silanhaftmittels ausgebildet ist.

4. Oberflächenbehandelte Kupferfolie mit einer sehr dünnen Grundiermittelharzschicht (6), **dadurch gekennzeichnet, dass** sie eine sehr dünne Grundiermittelharzschicht (6) umfasst mit einer äquivalenten Stärke von 1 $\mu$m bis 5 $\mu$m auf einer Oberfläche der oberflächenbehandelten Kupferfolie (5) gemäß Anspruch 1, die an ein isolierendes Harzsubstrat gebunden werden soll.

5. Oberflächenbehandelte Kupferfolie mit einer sehr dünnen Grundiermittelharzschicht (6) nach Anspruch 4, wobei die sehr dünne Grundiermittelharzschicht (6) ausgebildet ist durch Verwenden der Harzzusammensetzung umfassend 5 Gewichtsteile bis 50 Gewichtsteile eines Epoxyharzes (umfassend ein Vernetzungsmittel), 50 Gewichtsteile bis 95 Gewichtsteile eines Polyethersulfons, das in einem Lösungsmittel löslich ist, und einen optional hinzugefügten Vernetzungsbeschleuniger in einer erforderlichen Menge.

6. Oberflächenbehandelte Kupferfolie mit einer sehr dünnen Grundiermittelharzschicht (6) gemäß Anspruch 4, wobei ein Harzfluss der sehr dünnen Grundiermittelharzschicht (6), der von der Harzzusammensetzung gebildet ist, 5% oder weniger beträgt, wenn gemäß der Offenbarung in MIL-P-13949G der MIL-Spezifikationen gemessen.

7. Verfahren zum Herstellen einer oberflächenbehandelten Kupferfolie (5) gemäß einem der Ansprüche 1 bis 3, wobei das Verfahren umfasst Ausbilden einer Nickellegierungsschicht auf einer Bindungsoberfläche an ein isolierendes Harzsubstrat einer elektrochemisch hergestellten Kupferfolie, Ausbilden einer Zinnschicht auf der Nickellegierungsschicht, um eine Rostschutzbehandlungsschicht (3) fertigzustellen, und Ausbilden einer Silanhaftmittelschicht (4) durch Adsorbieren eines Silanhaftmittels auf einer Oberfläche der Zinnschicht, gefolgt von Trocknen des Silanhaftmittels, um die Silanhaftmittelschicht fertigzustellen, **dadurch gekennzeichnet, dass**
eine Lösung, in der das Silanhaftmittel in Wasser oder einem organischen Lösungsmittel dispergiert ist, um eine Konzentration von 0,5 g/L bis 10 g/L aufzuweisen, auf die Oberfläche der Zinnschicht adsorbiert wird und die Lösung getrocknet wird, um die Silanhaftmittelschicht (4) auszubilden.

8. Verfahren zum Herstellen einer oberflächenbehandelten Kupferfolie (5) nach Anspruch 7, wobei das Trocknen so durchgeführt wird, dass eine Folientemperatur der elektrochemisch hergestellten Kupferfolie 100°C bis 200°C beträgt.

9. Verfahren zum Herstellen der oberflächenbehandelten Kupferfolie (5) mit einer sehr dünnen Grundiermittelharzschicht (6) nach Anspruch 4, **dadurch gekennzeichnet, dass** es umfasst, dass die folgenden Schritte a und b sequentiell durchgeführt werden, um eine Harzlösung herzustellen, die bei der Ausbildung der sehr dünnen Grundiermittelharzschicht (6) verwendet werden soll, und die Harzlösung auf eine Oberfläche mit einer Silanhaftmittelschicht (4), die auf der Kupferfolie ausgebildet ist, in einer Menge aufgetragen wird, um eine äquivalente Stärke von 1 $\mu$m bis 5 $\mu$m auszubilden, gefolgt von Trocknen bis zu einem vorvemetzten Zustand:

Schritt a: eine Harzzusammensetzung wird hergestellt durch Mischen von 5 Gewichtsteilen bis 50 Gewichtsteilen eines Epoxyharzes (umfassend ein Vernetzungsmittel), 50 Gewichtsteilen bis 95 Gewichtsteilen eines Polyethersulfons, das in einem Lösungsmittel löslich ist, und eines optional in einer erforderlichen Menge hinzugegebenen Vemetzungsbeschleunigers, und
Schritt b: die Harzzusammensetzung wird gelöst unter Verwendung eines organischen Lösungsmittels, um eine Harzlösung herzustellen mit einem Harzgehalt von 10 Gew.-% bis 40 Gew.-%.

## Revendications

1. Feuille de cuivre sans chrome traitée en surface (5) comprenant une couche de traitement antirouille (3) et une couche d'agent de couplage à base de silane (4) sur une surface de liaison d'une feuille de cuivre électrodéposée (5) d'un substrat de résine isolante, **caractérisée en ce que**
la couche de traitement antirouille (3) est formée en empilant une couche d'alliage de nickel composée d'au moins un alliage choisi parmi le nickel-molybdène, le nickel-zinc et le nickel-molybdène-cobalt ayant une épaisseur en poids de 5 mg/m$^2$ à 50 mg/m$^2$ et une couche d'étain ayant une épaisseur en poids de 5 mg/m$^2$ à 40 mg/m$^2$ dans cet ordre sur la feuille de cuivre, la couche de traitement antirouille a une épaisseur en poids totale d'un alliage de nickel et d'étain de 10 mg/m$^2$ à 70 mg/m$^2$, la couche de traitement antirouille a un rapport [quantité de nickel dans l'alliage de nickel]/[quantité d'étain] de 0,25 à 10, et
la couche d'agent de couplage à base de silane (4) est appliquée sur une surface de la couche de traitement antirouille (3).

2. Feuille de cuivre traitée en surface selon la revendication 1, dans laquelle la surface de liaison de la feuille de cuivre électrodéposée (5) est soumise à un traitement de rugosification.

3. Feuille de cuivre traitée en surface selon la revendication 1, dans laquelle la couche d'agent de couplage à base de silane (4) est formée en utilisant un agent de couplage à base de silane aminofonctionnel ou un agent de couplage à base de silane époxyfonctionnel.

4. Feuille de cuivre traitée en surface avec une très fine couche de résine d'apprêt (6) **caractérisée en ce qu'**elle comprend une très fine couche de résine d'apprêt (6) ayant une épaisseur équivalente de 1 $\mu$m à 5 $\mu$m sur une surface de la feuille de cuivre traitée en surface (5) à lier à un substrat de résine isolante selon la revendication 1.

5. Feuille de cuivre traitée en surface avec une très fine couche de résine d'apprêt (6) selon la revendication 4, dans laquelle la très fine couche de résine d'apprêt (6) est formée en utilisant la composition de résine comprenant 5 parties en poids à 50 parties en poids d'une résine époxy (comprenant un durcisseur), 50 parties en poids à 95 parties en poids d'une polyéthersulfone qui est soluble dans un solvant, et un accélérateur de durcissement éventuellement ajouté dans une quantité nécessaire.

6. Feuille de cuivre traitée en surface avec une très fine couche de résine d'apprêt (6) selon la revendication 4, dans laquelle un écoulement de résine de la très fine couche de résine d'apprêt (6) formée à partir de la composition de résine est de 5 % ou moins lorsqu'il est mesuré selon l'exposé de MIL-P-13949G des spécifications MIL.

7. Procédé de fabrication d'une feuille de cuivre traitée en surface (5) selon l'une quelconque des revendications 1 à 3, le procédé comprenant la formation d'une couche d'alliage de nickel sur une surface de liaison à un substrat de résine isolante d'une feuille de cuivre électrodéposée, la formation d'une couche d'étain sur la couche d'alliage de nickel pour finir une couche de traitement antirouille (3), et la formation d'une couche d'agent de couplage à base de silane (4) par adsorption d'un agent de couplage à base de silane sur une surface de la couche d'étain suivie du séchage de l'agent de couplage à base de silane pour finir la couche d'agent de couplage à base de silane, **caractérisé en ce que** :

une solution dans laquelle l'agent de couplage à base de silane est dispersé dans de l'eau ou un solvant organique à une concentration de 0,5 g/l à 10 g/l est adsorbée sur la surface de la couche d'étain et la solution est séchée pour former la couche d'agent de couplage à base de silane (4).

8. Procédé de fabrication d'une feuille de cuivre traitée en surface (5) selon la revendication 7, dans lequel le séchage est réalisé pour faire en sorte que la température de feuille de la feuille de cuivre électrodéposé soit de 100 °C à 200 °C.

9. Procédé de fabrication de la feuille de cuivre traitée en surface (5) avec une très fine couche de résine d'apprêt (6) selon la revendication 4, **caractérisé en ce qu'**il comprend les étapes a et b suivantes réalisées séquentiellement pour préparer une solution de résine à utiliser dans la formation de la très fine couche de résine d'apprêt (6), et la solution de résine est déposée sur une surface ayant une couche d'agent de couplage à base de silane (4) formée sur la feuille de cuivre dans une quantité pour former une épaisseur équivalente de 1 $\mu$m à 5 $\mu$m, puis séchée pour être dans un état semi-durci :

étape a : une composition de résine est préparée en mélangeant 5 parties en poids à 50 parties en poids d'une résine époxy (comprenant un durcisseur), 50 parties en poids à 95 parties en poids d'une polyéthersulfone qui est soluble dans un solvant, et un accélérateur de durcissement éventuellement ajouté dans une quantité nécessaire, et
étape b : la composition de résine est dissoute en utilisant un solvant organique pour préparer une solution de résine ayant une teneur en résine de 10 % en poids à 40 % en poids.

Fig. 1

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 7170064 A
- JP 2004047681 A